(19) Europäisches Patentamt
European Patent Office
Office européen des brevets

(11)  EP 2 294 825 B1

(12)  **EUROPÄISCHE PATENTSCHRIFT**

(45) Veröffentlichungstag und Bekanntmachung des Hinweises auf die Patenterteilung:
08.10.2014  Patentblatt 2014/41

(21) Anmeldenummer: **09772092.4**

(22) Anmeldetag: **18.06.2009**

(51) Int Cl.:
*H04N 19/14* (2014.01)      *H04N 19/63* (2014.01)
*H04N 19/12* (2014.01)      *H04N 19/176* (2014.01)
*H04N 19/593* (2014.01)     *H04N 19/182* (2014.01)
*H03M 7/24* (2006.01)       *H04N 19/13* (2014.01)

(86) Internationale Anmeldenummer:
**PCT/EP2009/004397**

(87) Internationale Veröffentlichungsnummer:
**WO 2010/000392 (07.01.2010 Gazette 2010/01)**

(54) **VORRICHTUNG UND VERFAHREN ZUM CODIEREN UND DECODIEREN EINER MEHRZAHL VON FLIESSKOMMAWERTEN**

DEVICE AND METHOD FOR ENCODING AND DECODING A PLURALITY OF FLOATING POINT VALUES

DISPOSITIF ET PROCÉDÉ POUR CODER ET DÉCODER UNE PLURALITÉ DE VALEURS À VIRGULE FLOTTANTE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **02.07.2008  DE 102008031400**

(43) Veröffentlichungstag der Anmeldung:
**16.03.2011  Patentblatt 2011/11**

(73) Patentinhaber: **Fraunhofer-Gesellschaft zur Förderung der angewandten Forschung e.V.
80686 München (DE)**

(72) Erfinder:
• **SPRINGER, Dominic
91284 Neuhaus (DE)**
• **KAUP, André
91090 Effeltrich (DE)**

(74) Vertreter: **Schenk, Markus et al
Schoppe, Zimmermann, Stöckeler & Zinkler Patentanwälte
Hermann-Roth-Weg 1
82043 Pullach bei München (DE)**

(56) Entgegenhaltungen:
**JP-A- 2006 186 529**

• **MARTIN ISENBURG, PETER LINDSTROM, JACK SNOEYINK: "Lossless Compression of Floating-Point Geometry" PROCEEDINGS OF CAD04, [Online] 24. Mai 2004 (2004-05-24), - 28. Mai 2004 (2004-05-28) XP002558963 Pattaya, Thailand Gefunden im Internet: URL:http: //www.cs.unc.edu/~isenburg/papers /ils-lcfpg-04.pdf> [gefunden am 2009-12-03]**
• **ERIC REINHARD ET AL: "HIGH DYNAMIC RANGE IMAGING" 30. November 2005 (2005-11-30), ELSEVIER , AMSTERDAM , XP040425801 ISBN: 9780125852630 Seiten 85,97,98; Tabellen 3.1,3.2**
• **GAMITO M N ET AL: "Lossless Coding of Floating Point Data with JPEG 2000 Part 10" PROCEEDINGS OF THE INTERNATIONAL SOCIETY FOR OPTICAL ENGINEERING, SPIE, US, Bd. 5558, 2. August 2004 (2004-08-02), Seiten 276-287, XP002388575 ISSN: 0277-786X**
• **KNEZOVIC J ET AL: "Gradient based selective weighting of neighboring pixels for predictive lossless image coding" PROCEEDINGS OF THE 25TH IEEE CONFERENCE ON INFORMATION TECHNOLOGY INTERFACES, 16. Juni 2003 (2003-06-16), - 19. Juni 2003 (2003-06-19) Seiten 483-488, XP010654766 PISCATHAWAY, NJ, USA ISBN: 978-953-96769-6-2**

EP 2 294 825 B1

- BRYAN E. USEVITCH: "JPEG2000 Compatible Lossless Coding of Floating-Point Data" EURASIP JOURNAL ON IMAGE AN VIDEO PROCESSING, [Online] Bd. 2007, 31. Dezember 2007 (2007-12-31), XP002558964 ISSN: 1687-5176 Gefunden im Internet: URL:http://www.hindawi.com/journals/ivp/2007/085385.cta.html> [gefunden am 2009-12-03]
- D. SPRINGER: "Lossless and lossy Floating Point Compression with JPEG2000" 43RD MEETING OF ISO/IEC JTC 1/SC 29/WG 1, WG1N4461, 16. November 2007 (2007-11-16), XP002571679 Kobe, JP
- ISO/IEC JTC 1/SC 29/WG 1: "Meeting Report, 43rd Meeting of ISO/IEC JTC 1/SC 29/WG 1" Information Technology Standards Commision of Japan Nr. ISO/IEC JTC 1/SC 29/WG 1 N4479, 19. November 2007 (2007-11-19), XP002571828 Kobe, JP Gefunden im Internet: URL:http://www.itscj.ipsj.or.jp/sc29/open/ 29view/29n89661.pdf> [gefunden am 2010-03-04]

**Beschreibung**

Die vorliegende Erfindung bezieht sich auf eine Vorrichtung und ein Verfahren zum Codieren und Decodieren einer Mehrzahl von Fließkommawerten unter Einbeziehung einer Nachbarschaft oder des jeweiligen Kontextes.

Die Notwendigkeit einer effizienten Kompression von Fließkomma-Daten ist in den letzten Jahren deutlich gewachsen. Gesucht wird vor allem nach verlustlosen Kompressionsverfahren, da in vielen Fällen eine 1:1-Rekonstruktion der Daten gefordert wird. Aus diesem Grund sind Verfahren für verlustlose Kompression besonders wichtig. Nachfolgend werden einige der wichtigsten Anwendungsgebiete für verlustlose Fließkomma-Kompression kurz aufgelistet. Allen gemeinsam ist der enorme Umfang der anfallenden bzw. produzierten Fließkomma-Daten:

  (1) Helligkeitsberechnungen künstlicher Szenen (Rendering);
  (2) Mixed-Reality-Rendering (Spezialeffekte in Werbespots und Filmen);
  (3) Wissenschaftliche Simulationen (Wettermodelle, Materialbeanspruchung etc.);
  (4) Aufnahmen von Satelliten und Teleskopen, Sensordaten aller Art;
  (5) HDR-Aufnahmen (HDR = High Dynamic Range) im Bereich der professionellen Fotografie und
  (6) Digitales Kino, digitale Postproduktion von Filmmaterial.

Ein effizientes Kompressionsverfahren würde für jeden der genannten Bereiche den Vorteil einer deutlichen Datenreduktion bieten. Da ein besonderes Interesse auf eine verlustlose Kompression von Fließkomma-Bildmaterial liegt, soll das Anwendungsgebiet HDR kurz beschrieben werden.

Bei herkömmlichen Bildern wird die Bildinformation im Integer-Format gespeichert. Das Integer-Format basiert auf einer Quantisierung von Helligkeitswerten mittels ganzer Zahlen, z. B. indem ein darzustellender Helligkeitsbereich in N Schritte unterteilt wird, wobei $N = 2^n$ und n eine ganze Zahl ist (z.B. Bittiefe). Der dargestellte Helligkeitsbereich und somit der Informationsgehalt orientiert sich dabei an den Darstellungsmöglichkeiten konventioneller Monitore und Drucker. Dabei steht für die Darstellung unterschiedlicher Farbwerte und Helligkeiten bei einer Bittiefe von 8 Bit pro Kanal lediglich ein Dynamikbereich von 0 bis 255 zur Verfügung; bei 16 Bit pro Kanal sind 65536 unterschiedliche Helligkeitswerte möglich. Dies entspricht einem darstellbaren Dynamikumfang von 2.4 bei einer Bittiefe von 8 bzw. 4.8 bei einer Bittiefe von 16, wobei sich der Dynamikumfang als logarithmiertes Verhältnis des maximalen zum minimalen Intensitätswert berechnet. Die Helligkeits- bzw. Farbrepräsentation mittels ganzer Zahlen (Integer-Zahlen) folgt der technischen Begrenzung heutiger Ausgabegeräte (Handheld-Display, Monitore, Drucker, etc.) hinsichtlich Kontrastverhältnis und darstellbarer Helligkeit. Diese Integer-Bilder (= Bilder im Integer-Format) werden deshalb als "device referred" oder "output referred" bezeichnet, da nur jene Bildinformationen gespeichert sind, die vom beabsichtigten Ausgabegerät (device, output) auch angezeigt oder ausgegeben werden können.

Ein Beispiel für eine Kompression von Bildern im Integer-Format ist JPEG2000. Die Schritte des JPEG2000-Codierprozesses umfassen ein optionales Aufteilen des Bildes in sogenannte Kacheln oder Tiles, d.h. rechteckige Bildbereiche, eine Gleichsignalanteilpegelverschiebung, eine optionale Transformation der Farbkomponenten, die Durchführung einer diskreten Wavelet-Transformation, eine skalare Quantisierung der Wavelet-Koeffizienten, eine Anordnung der quantisierten Wavelet-Koeffizienten in zweidimensionalen Feldern, sogenannten "Codeblöcken", eine Block-Codierung umfassend einen sogenannten "Koeffizientenbitmodellierprozess" und einen arithmetischen Codiervorgang sowie ein Anordnen der codierten Codeblock-Daten zu einem standardkonformen Codierstrom. Die Codeblöcke können beispielsweise 8x8 Bildpunkte umfassen, wobei andere Werte gleichermaßen möglich sind. Die Durchläufe können parallelisiert werden, so dass weniger Taktzyklen zur Codierung der Codeblöcke notwendig sind. Neben einem Speicher zur Speicherung der Betragsbits und Vorzeichenbits ist dabei ein Puffer zur Zwischenspeicherung aktualisierter Signifikanzstatusvariablen zwischen einer Verarbeitungseinheit vorgesehen, die sich um den ersten Codierdurchlauf kümmert, und einer zweiten Verarbeitungseinheit, die für die Codierdurchläufe 2 und 3 zuständig ist.

HDR-Bilder hingegen bezeichnet man als "scene referred". Dahinter steht der Versuch, alle Helligkeitswerte der aufgenommenen Szene so genau und umfassend wie möglich einzufangen und zu sichern. Dabei werden die Samples der Kanäle beispielsweise durch 16- oder 32-Bit Fließkommazahlen repräsentiert, was einer verfügbaren Dynamik im positiven Zahlenbereich von $5{,}9 \cdot 10^{-8}$ bis $6{,}5 \cdot 10^4$ (16 Bit) bzw. $1{,}1 \cdot 10^{-38}$ bis $3{,}4 \cdot 10^{38}$ (32 Bit) entspricht. Eine Fließkommazahl kann dabei beispielsweise wie folgt dargestellt werden (IEEE 754 Standard): durch ein Vorzeichenbit, ein n-bit Exponentenfeld $a = a_0 a_1 ... a_n$ und ein m-bit Mantissenfeld $b = b_0 b_1 ... b_m$. Je nach Präzision (16, 32 oder 64-Bit) besitzen das Exponenten- und das Mantissenfeld unterschiedliche Größen. So besteht eine 32-Bit Fließkommazahl aus einem Vorzeichenbit, gefolgt von 8 Exponentenbits und 23 Mantissenbits. Der Zusammenhang zwischen einer reellen Zahl und deren 32-Bit Fließkomma-Reparäsentation ist dabei wie folgt: $x = \pm [1.b_0 b_1 ... b_m]_2 \cdot 2^{a-127}$. Die "1" links vor dem Komma ist fest definiert, die Bits des Mantissenfelds repräsentieren die Nachkommastellen. Die resultierende Zahl zur Basis 2 wird mit einer Zweierpotenz multipliziert, welche sich aus dem Wert des Exponentenfelds abzüglich eines Biaswertes von 127 berechnet.

Bilder, deren Samples mit 16 Bit Fließkomma pro Kanal repräsentiert werden (sog. HALF-Format und Standard bei der Postproduktion von Filmmaterial), besitzen einen Dynamikumfang von 12,0 und eignen sich hervorragend zur Speicherung extrem kontrastreicher Szenen. Zudem ist eine nachträgliche Korrektur von Helligkeiten oder Farben möglich, ohne dass dabei ein Qualitätsverlust wie bei Integerbildern zu verzeichnen wäre. Die Repräsentation der Szeneninformation im Fließkomma-Format führt allerdings zu großem Speicherplatzbedarf, welcher durch bekannte Kompressionsverfahren nur eingeschränkt reduziert werden kann.

Es existieren einige konventionelle Verfahren, die sich mit der verlustlosen Kompression von Fließkomma-Zahlen beschäftigen. Verlustbehaftete Kompressionen sind oft nur bedingt von Interesse und sollen im Folgenden nicht weiter betrachtet werden. Eine verlustlose Kompression von 2:1 wäre in vielen Bereichen wünschenswert und stellt momentan das angestrebte Ziel aller Bemühungen dar. Das zur Zeit effizienteste Verfahren, die PIZ-Kompression (Kombination aus Wavelet/Huffman-Kompression), erreicht für typische Fließkomma-Bilder allerdings nur ein Kompressionsverhältnis von 1,6:1. Das grundsätzliche Problem bei der verlustlosen Kompression von Fließkomma-Zahlen stellt die Mantisse dar. Sie ist mit einer Entropie-Codierung kaum zu komprimieren. Ein Grund dafür sind die großen Sprünge zwischen benachbarten Mantissenwerten. Die Sprünge werden zum einen verursacht durch wechselnde Exponenten, d.h. durch das Eintreten der Fließkommazahl in höhere bzw. niedrigere Wertebereiche (z. B. in einer Umgebung von Null). Zum anderen können auch bei konstantem Exponenten große Sprünge der Mantisse eintreten. Dies ist vor allem dann der Fall, wenn sich die Fließkommazahlen im unteren Wertebereich des möglichen Dynamikumfangs befinden und dadurch auch kleine Unterschiede zwischen benachbarten Zahlen in großen Unterschieden der zugehörigen Mantissen resultieren. Ein Grund für dieses Verhalten ist die starke Nichtlinearität von Fließkommazahlen, z. B. im IEEE 754 Format - der Standard für binäre Fließkommawert-Arithmetik für Mikroprozessor Systeme (siehe Beispiele weiter unten).

Dieses starke Sprungverhalten der Mantisse ist ein grundsätzliches Problem bei der Kompression von Fließkommazahlen, da Vorhersagen (beispielsweise im Rahmen einer Entropie-Codierung) in den seltensten Fällen zutreffen. Bekannte Verfahren führen eine Codierung der Mantisse durch, ohne die Abhängigkeit der Mantisse vom Exponenten zu berücksichtigen. Eine Nutzung der Korrelation von Exponent und Mantisse sollte aber mit deutlichen Bitraten-Gewinnen verbunden sein. ISENBURG et al. "Lossless Compression of Floating-Point Geometry" in PROCEEDINGS OF CAD04 (2004-05-24) beschäftigt sich mit der verlustlosen Kompression von Fließkomma-Daten zur Codierung von Positionskoordinaten der Knotenpunkte geometrischer 3D-Modelle. Fließkomma-Koordinaten werden mittels einer Extrapolation auf Basis benachbarter Knotenpunkte geeignet prädiziert, um auf Basis der sich ergebenden Fließkomma-Prädiktoren aktuell zu codierende Koordinaten zu codieren. Insbesondere schlägt das Dokument ein Vorgehen vor, wonach zur Codierung einer Fließkomma-Koordinate zunächst ihr Exponent arithmetisch codiert wird, und zwar mit der Schätzung einer Wahrscheinlichkeitsverteilung, die von dem prädizierten Exponenten abhängt. Wenn dann das prädizierte Vorzeichen gleich dem tatsächlichen Vorzeichen ist, wird neben der Codierung dieser Tatsache die Codierung der Mantisse vorgenommen, und zwar abhängig von einem Vergleich des tatsächlichen Exponenten mit dem prädizierten Exponenten, und zwar derart, dass die Mantissendifferenz arithmetisch codiert wird, wenn prädizierter und tatsächlicher Exponent gleich waren, die Differenz aus tatsächlicher Mantisse und dem größtmöglichen Wert aus dem Definitionsbereich der Mantisse codiert wird, wenn der prädizierte Exponent größer als der tatsächliche war, und die tatsächliche Mantisse codiert wird, wenn der prädizierte Exponent kleiner als der tatsächliche Exponent war, wobei auch bei der Mantissencodierung der tatsächliche Exponent zur Auswahl des Kontextes herangezogen wird. In GAMITO et al. "Lossless Coding of Floating Point Data with JPEG 2000 Part 10" in PROCEEDINGS OF THE INTERNATIONAL SOCIETY FOR OPTICAL ENGINEERING, SPIE, US, Bd. 5558, Seiten 276-287 (2004-08-02) wird vorgeschlagen, Fließ-Zahlen, die Helligkeitswerten eines digitalen Bildes entsprechen, in ihre Vorzeichen, Exponenten und Mantisse zu zerlegen, und jedes so erhaltene Feld unabhängig drei vorzeichenlosen JPEG 2000-Bildern zuzuweisen, die dann einzeln jedes für sich komprimiert werden. Für das Mantissenfeld erfolgt eine signaladaptive Umschaltung des Codierverfahrens für verschiedene Bildbereiche. Das Bild wird in Regionen segmentiert, die jeweils ausschließlich Fließkommawerte mit konstantem Vorzeichen und Exponenten aufweisen. Sogenannte "zero regions" (alle Werte gleich Null) werden von den restlichen Segmenten separiert und zur Codierung nicht der dekorrelierenden wavelet-Transformation unterzogen.

Ausgehend von diesem Stand der Technik besteht ein Bedarf nach einer Codierung für Fließkommazahlen oder Fließkommawerte, die Helligkeitswerten eines digitalen Bildes entsprechen, auf deren Basis eine möglichst effiziente Kompression möglich wird.

Diese Aufgabe wird von einer Vorrichtung nach Anspruch 1 oder 5 und einem Verfahren nach Anspruch 13 oder 14 gelöst.

Der Kerngedanke der vorliegenden Erfindung besteht darin, dass die Entropie der Mantissenwerte dadurch reduziert werden kann, dass zunächst ein Schätzwert für einen bestimmten Mantissenwert erzeugt wird und anschließend die Differenz (Restwert oder Residual) zwischen dem Schätzwert und dem tatsächlichen Mantissenwert für die Codierung genutzt wird. Der Schätzwert wird dabei unter Nutzung der Nachbarschaft mit Hilfe einer Extrapolation ermittelt, so dass eventuell auftretende Sprünge in den Exponenten, die wiederum eine wesentliche Ursache für die hohe Entropie der Mantissenwerte ist, bereits abgeschätzt werden können.

Die genannte Extrapolation kann beispielsweise auf eine einfache lineare Extrapolation beruhen, wobei beispielsweise zwei benachbarte Fließkommawerte linear extrapoliert werden, um die Schätzwerte zu erhalten. Damit kann beispielsweise ein Trend weiterverfolgt oder vorhergesagt werden. Vorteilhaft ist es dabei, wenn mittels eines Gradientenverfahrens jene Nachbarschaftswerte bestimmt werden, die bei der Extrapolation eine möglichst geringe Abweichung vom optimalen Schätzwert liefern. Hierfür wird der kleinste Gradient in der Nachbarschaft bestimmt, die so gefunden Richtung bestimmt die Auswahl der für die Schätzung zu verwendenden Nachbarschaftswerte. Diese Vorgehensweise basiert auf der Annahme, dass der kleinste Gradient vermutlich jene Richtung einnimmt, in welcher auch die lokal vorherrschende Textur verläuft. Dies verhindert eine Schätzung über Kanten hinweg und fördert die Bildung eines guten Schätzwertes.

Die Nachbarschaft bezieht sich dabei beispielsweise auf die räumliche Nähe wie z. B. benachbarte Pixel in einem zu codierenden Bild, d.h. die Nachbarschaft ist nicht unbedingt zur Ordnung in einem Datenstrom korreliert. Die Nachbarschaft kann sich allerdings auch auf eine zeitliche Nähe der Fließkommawerte beziehen. Es ist auch möglich, dass sich die Nachbarschaft lediglich auf eine isolierte Teilmenge der Menge von Fließkommawerte bezieht, wenn z. B. in der Teilmenge die Fließkommawerte eine Korrelation aufweisen, so dass sie für die Extrapolation geeignet sind. Diese Korrelation kann sich auch auf zeitlich entfernt liegende Daten (Fließkommawerte) beziehen. In Abhängigkeit von der gewählten Anwendung (z. B. Bildcodierung oder Videocodierung) kann die Nachbarschaft derart gewählt werden, dass sie korrelierte Daten (z.B. benachbarte Bildpunkte) umfasst.

Die genannte lineare Extrapolation zur Erhaltung des Schätzwertes kann bei weiteren Ausführungsbeispielen optional weiter optimiert werden, z.B. durch die Einbeziehung weiterer Nachbarn, so dass auch beschleunigt anwachsende oder beschleunigt fallende Fließkommawerte hinreichend genau extrapoliert werden können. Das kann beispielsweise dadurch erreicht werden, dass die lineare Extrapolation durch eine quadratische oder kubische (oder mit noch höherem Grad) ersetzt wird. Das verwendete Extrapolationsverfahren kann sich nach der zur Verfügung stehenden Rechenkapazität und der damit erreichten Rechenzeit richten.

Das damit beschriebene kontextabhängige Prädiktionsverfahren kann sowohl für die verlustlose als auch für die verlustbehaftete Kompression von Fließkomma-Datensätzen eingesetzt werden. Der Kontext bestimmt sich über die Nachbarschaft und bezieht das Verhalten des zugehörigen Exponenten mit ein. Im Folgenden wird ein Verfahren detaillierter vorgestellt, das mittels einer kontextbasierten Mantissenvorhersage Nutzen aus der genannten Korrelation zwischen Mantisse und Exponent zieht.

Der Ablauf der Kompression oder Codierung kann beispielsweise wie folgt gestaltet werden:

Für jeden Fließkomma-Kanal:

Für jeden geeigneten Block:

Für jede enthaltene Fließkommazahl:

Bilde einen Schätzwert dieser Fließkommazahl auf Basis der vorhergehenden Fließkommazahlen;
Bestimme die Differenz zwischen der Mantisse der Fließkommazahl und der Mantisse des Schätzwerts;
Ersetze den Mantissenwert der Fließkommazahl mit der berechneten Differenz (= Residual);

Führe eine arithmetische Codierung des Blocks durch;

Für jeden nicht geeigneten Block von Samples:

Führe direkt eine arithmetische Codierung der Fließkommazahlen des Blocks durch.

Als Fließkommakanal ist beispielsweise einer der drei Farbkanäle (Rot, Grün, Blau) eines RGB-Bildes zu verstehen. Ein Schätzwert kann beispielsweise durch eine lineare Extrapolation auf Basis der berechneten, lokalen Gradienten bestimmt werden. Je genauer die Schätzung, umso kleiner das Residual (=Abweichung des tatsächlichen Wertes von dem Schätzwert). Bei der Kompression von Bildern (z. B. bei JPEG 2000) wird häufig eine rasterartige Zerlegung des Bildes in einzelne Blöcke vorgenommen. Der Block beschreibt somit beispielsweise eine Vielzahl von Pixel in einer bestimmten Region des Bildes. Die Eignung eines Blockes kann beispielsweise aus dem Sprungverhalten der enthaltenen Exponentenwerte bestimmt werden: Treten große Sprünge auf, kann von vielen Fehlschätzungen ausgegangen werden, der Block wird dann als ungeeignet eingestuft und ohne Prädiktion (d.h. ohne Extrapolation) codiert. Bei einem geeigneten Block von Fließkommawerten schwankt der Exponent beispielsweise kaum. Das ist z. B. der Fall, wenn die Schwankungsbreite oder die Standardabweichung in einer Statistik von Exponentenwerten unterhalb eines bestimmten Grenzwertes liegt (z.B. maximal um $\pm 2$ oder $\pm 4$ innerhalb des Blockes schwankt). Die noch akzeptable Schwankungsbreite des Exponenten kann auch durch eine Optimierung des Ergebnisses zum Aufwand ermittelt werden, wobei das Ergebnis z. B. die erreichte Kompression und der Aufwand beispielsweise den (zeitlichen) Rechenaufwand einschließen kann.

Ausführungsbeispiele können für Kompressionsverfahren für Fließkomma-Bilder im 16- und 32-Bit Format genutzt werden und basieren auf einer Zerlegung der Fließkomma-Kanäle in jeweils eine Vorzeichen-, Exponenten- und Mantissenkomponente. Die Exponentenkomponente wird dabei beispielsweise vor der Mantissenkomponente komprimiert bzw. dekomprimiert. Da die Kanäle bereits in Vorzeichen-, Exponenten- und Mantissenwerte zerlegt sind, wird die direkte Anwendung des Mantissenprädiktionsverfahrens möglich. Während der JPEG2000-Kompression werden hierbei Codeblöcke der Mantisse auf die oben beschriebene Eignung überprüft (abhängig vom Inhalt des zugehörigen Exponenten-Codeblocks) und entsprechend prädiziert. Nachdem die Mantisse auf diese Weise vorverarbeitet wurde, kann sie der üblichen Entropie-Codierung zugeführt werden (optional mit vorgeschalteter Wavelet-Transformation).

Eine Zerlegung der Fließkomma-Bestandteile in Vorzeichen, Exponent und Mantisse liefert bei 3-Kanal-HDR-Bildern (beispielsweise RGB) insgesamt 9 Komponenten. Die Verarbeitung aller 9 Komponenten mittels JPEG2000 stellt einen großen Rechenaufwand dar und kann, bezogen auf den spezifischen Anwendungsfall, unter Umständen nicht praktikabel sein. Eine Alternative zu diesem Vorgehen ist die Interpretation der 16- bzw. 32-Bit Fließkommazahlen als Integerzahlen, auch *Casting* genannt. Diese Integerzahlen, welche die Bitmuster der eigentlichen Fließkommazahl enthalten, werden unverändert an die JPEG2000-Kompression übergeben. So resultieren aus einem 3-Kanal-HDR-Bilder lediglich 3 JPEG2000-Komponenten. Auch dieses Vorgehen eignet sich für den Einsatz der Mantissenprädiktion. Anders als im zuvor genannten Ausführungsbeispiel erfolgt die Mantissenprädiktion aber nicht im Zuge der JPEG2000-Kompression, sondern kann als Vorverarbeitungsstufe ausgeführt werden, wobei einmalig für alle Kanäle eine Mantissenprädiktion angewendet wird. Als Block-Größe kann dabei die in der nachfolgenden JPEG2000-Kompression definierte Codeblock-Größe gewählt werden. Das Bitmuster der letzten 10 bzw. 23 Stellen (= Mantissenbitmuster) wird durch das Bitmuster jener Differenz ersetzt, die sich zwischen der tatsächlichen und der geschätzten Mantisse ergibt (=Restwert, Residual). Anschließend werden die so vorverarbeiteten Kanäle auf Integerwerte gecastet und der JPEG2000-Kompression übergeben. Auch hier wird eine deutliche Steigerung der Kompressionseffizienz erreicht.

Um eine zuverlässige Rekonstruktion der Daten zu gewährleisten werden bei der Dekompression die gleichen Kriterien zur Entscheidungsfindung angewendet wie bei der Kompression. Anderenfalls würde es zu Fehlinterpretationen der Samplewerte des Blocks kommen. Seiteninformationen, z. B. welche Extrapolationsrichtung bei der Mantissenprädiktion verwendet wurde, brauchen hierfür nicht eingebunden zu werden, da die für die Entscheidung notwendige Information aus den bereits dekomprimierten Fließkommawerten gewonnen werden kann. Schematisch lässt sich der Dekompressionsablauf folgendermaßen zusammenfassen:

Für jeden Fließkomma-Kanal:

Für jeden geeigneten Block von Samples:

Decodiere die enthaltenen Residual-Werte mit Hilfe des arithmetischen Codierers;
Für jeden decodierten Residual-Wert:

Bilde auf Basis der vorhergehenden Fließkommazahlen einen Schätzwert der folgenden Fließkommazahl;
Addiere die Mantisse des Schätzwerts und den zugehörige Residual-Wert;
Ersetze den Residual-Wert im Block mit dem Ergebnis der Addition;

Für jeden nicht geeigneten Block von Samples:

Führe direkt eine arithmetische Decodierung der Fließkommazahlen des Blocks durch.

Ausführungsbeispiele umfassen somit ebenfalls eine Vorrichtung zum Decodieren einer Mehrzahl von codierten Fließkommawerten mit einer Einrichtung zum Decodieren, einer Einrichtung zum Extrapolieren und einer Einrichtung zum Ermitteln auf. Die Einrichtung zum Decodieren decodiert die codierten Fließkommawerte in einer Nachbarschaft eines vorbestimmten Fließkommawertes aus der Mehrzahl von Fließkommawerten. Ferner wird in der Einrichtung zum Decodieren ein mantissen-Restwert und ein Exponent des vorbestimmten Fließkommawertes decodiert. Die Einrichtung zum Extrapolieren extrapoliert die Fließkommawerte aus der Nachbarschaft, um einen Schätzwert (S) für den vorbestimmten Fließkommawert (I) zu erhalten. Schließlich ermittelt die Einrichtung zum Ermitteln einen Mantissenwert des vorbestimmten Fließkommawertes aus dem Mantissen-Restwert und aus dem Schätzwert.

Ausführungsbeispiele beschreiben somit die Funktionsweise und die Einsatzmöglichkeiten eines Verfahrens zur Vorhersage von Mantissenwerten z. B. während der Kompression von Fließkommazahlen. Das Verfahren nutzt eine bisher nicht beachtete Korrelation zwischen Exponent und Mantisse und berücksichtigt die Nichtlinearität von IEEE 754 Fließkommazahlen. Das beschriebene Prädiktionsverfahren ist in der Lage, die Entropie der Mantissenbitmuster von Fließkommazahlen mittels der Berücksichtigung des Sprungverhaltens der zugehörigen Exponenten-Komponenten zu reduzieren. Dies wiederum resultiert in Bitraten-Gewinnen bei der EntropieCodierung. Die Effizienz des Verfahrens ist direkt abhängig von der Qualität der Vorhersagen und kann - entsprechend gute Vorhersagewerte vorausgesetzt - eine Wavelet-Transformation der Mantissenkomponente möglich machen. Die Mantisse von Fließkommazahlen eignet sich nämlich in ihrer ursprünglichen, dem IEEE 754 Standard folgenden Form grundsätzlich nicht für eine Wavelet-Transformation, da die großen Sprünge zu großen Frequenzen oder Wavelet-Koeffizienten führen.

Weitere Ausführungsbeispiele der vorliegenden Erfindung werden nachfolgend Bezug nehmend auf die Figuren näher erläutert. Es zeigen:

Fig.1a,b      eine schematische Darstellung einer Vorrichtung zum Codieren und Decodieren;

Fig.2a,b      zeigen eine Zerlegung von zwei Graphen, deren y-Funktionswerte durch 16-Bit Fließkommazahlen repräsentiert werden, in eine Exponenten- und Mantissendarstellung;

Fig.3a,b      zeigen eine Schrittfolge bei der Ausführung eines Verfahrens gemäß Ausführungsbeispielen;

Fig.4      zeigt eine Nachbarschaft eines zu schätzenden Fließkommawertes;

Fig.5      zeigt eine schematische Darstellung für das verwendete Gradientenverfahren;

Fig.6      zeigt beispielhaft die Erzeugung eines Schätzwertes gemäß Ausführungsbeispielen;

Fig.7a-c      veranschaulichen die Verbesserung hinsichtlich der Mantissenwerte und der Nutzung der Schätzwerte; und

Fig.8a,b      zeigen schematisch eine Anwendung von Ausführungsbeispielen für die Codierung von Bildern.

Bevor im Folgenden die vorliegende Erfindung anhand der Zeichnungen näher erläutert wird, wird darauf hingewiesen, dass gleiche oder gleichwirkende Elemente in den Figuren mit den gleichen oder ähnlichen Bezugszeichen versehen sind, und dass eine wiederholte Beschreibung dieser Elemente weggelassen wird.

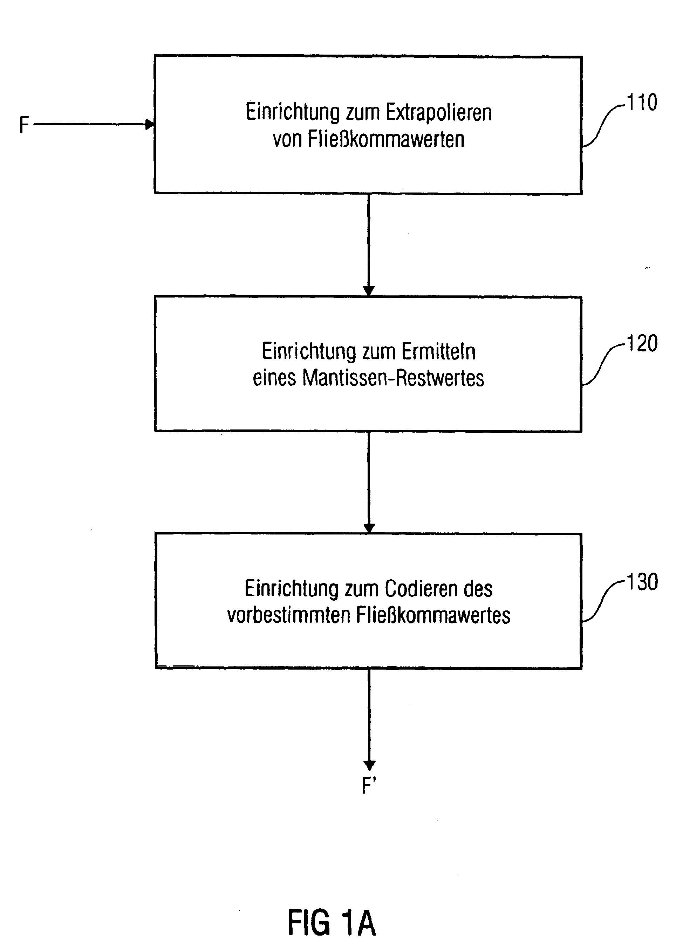

Fig. 1a zeigt eine schematische Darstellung einer Vorrichtung zur Codierung einer Mehrzahl von Fließkommawerten F. Die Mehrzahl weist einen vorbestimmten Fließkommawert mit einer Nachbarschaft von Fließkommawerten auf und wird in eine Einrichtung zum Extrapolieren 110 eingegeben. In der Einrichtung zum Extrapolieren 110 von Fließkommawerten wird aus der Nachbarschaft ein Schätzwert für den vorbestimmten Fließkommawert ermittelt. Daran anschließend ermittelt eine Einrichtung zum Ermitteln 120 eines Mantissen-Restwertes den Mantissen-Restwert abhängig von einer Differenz der Mantisse des Schätzwertes und der Mantisse des vorbestimmten Fließkommawertes. Dazu kann beispielsweise eine Differenz zwischen dem Schätzwert und dem vorbestimmten Fließkommawert gebildet werden. Der Mantissen-Restwert ersetzt dann den Mantissenwert der vorbestimmten Fließkommazahl. Schließlich erfolgt eine Codierung der Mehrzahl von Fließkommawerten F mittels einer Einrichtung zum Codieren 130. Die Einrichtung zum Codieren 130 codiert den Mantissen-Restwert und kann darüber hinaus auch den Exponenten und das Vorzeichen des vorbestimmten Fließkommawertes mit einer vorbestimmten Genauigkeit codieren.

Die hohe Entropie der ursprünglichen Mantissenwerte der Mehrzahl von Fließkommawerten F ist somit durch das Ermitteln des Restwertes verringert worden. Durch die Interpretation der Restwerte als neue Mantissenwerte der Mahrzahl von Fließkommawerten F und die dadurch reduzierte Entropie der Mantissenwerte eignet sich die Mehrzahl von Fließkommawerten F deutlich besser für eine Kompression.

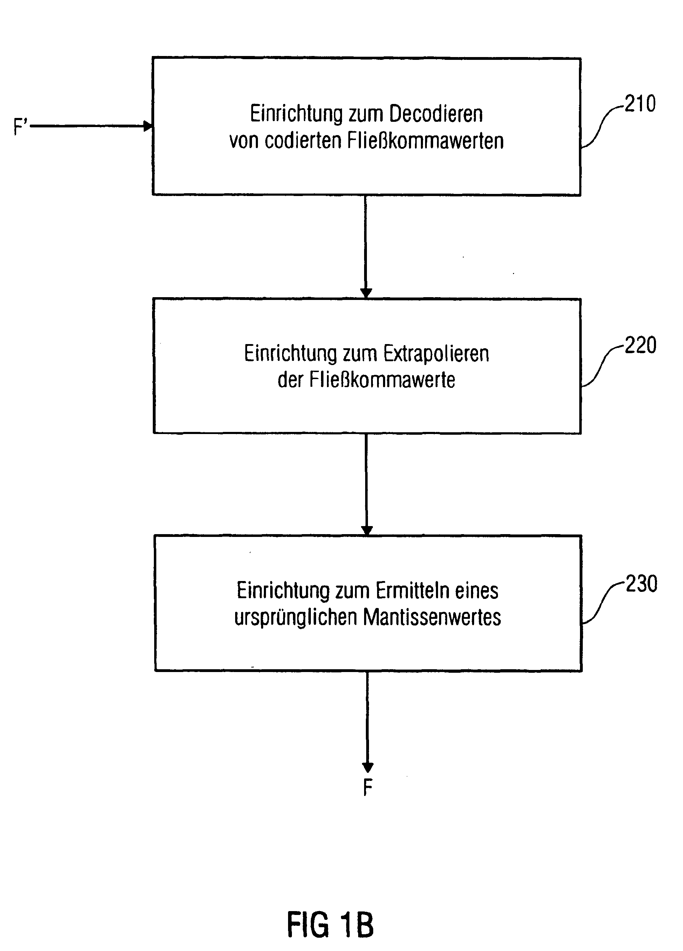

Die Fig. 1b zeigt eine schematische Darstellung einer Vorrichtung zur Decodierung einer Mehrzahl von codierten Fließkommawerten F'. Diese Vorrichtung kehrt somit den Prozess, der in der Fig. 1a beschrieben wurde wieder um, so dass aus den codierten Fließkommazahlen wieder die ursprünglichen Fließkommazahlen erhalten werden. In der Vorrichtung wird ein Datenstrom mit einer Mehrzahl von codierten Fließkommawerten F' decodiert, wobei in den codierten Fließkommawerten F' ein vorbestimmter Fließkommawert I mit einem Mantissen-Restwert codiert ist. Die Vorrichtung zum Decodieren weist folgende Merkmale auf. In einer Einrichtung zum Decodieren 210 der codierten Fließkommazahlen F' wird zunächst aus dem Datenstrom eine Mehrzahl von Fließkommawerten F und der vorbestimmte Fließkommawert decodiert, wobei die Mehrzahl von Fließkommawerte F eine Nachbarschaft zum vorbestimmten Fließkommawert I aufweist. Außerdem extrapoliert eine Einrichtung zum Extrapolieren 110 von Fließkommawerten F aus der Nachbarschaft einen Schätzwert S für den vorbestimmten Fließkommawert I. Schließlich ermittelt eine Einrichtung zum Ermitteln 230 einen ursprünglichen Mantissenwert aus dem Mantissen-Restwert und aus dem Schätzwert S. Dieser ursprüngliche Mantissenwert ersetzt dann den Mantissen-Restwert, der in dem vorbestimmten Fließkommawert I enthalten ist.

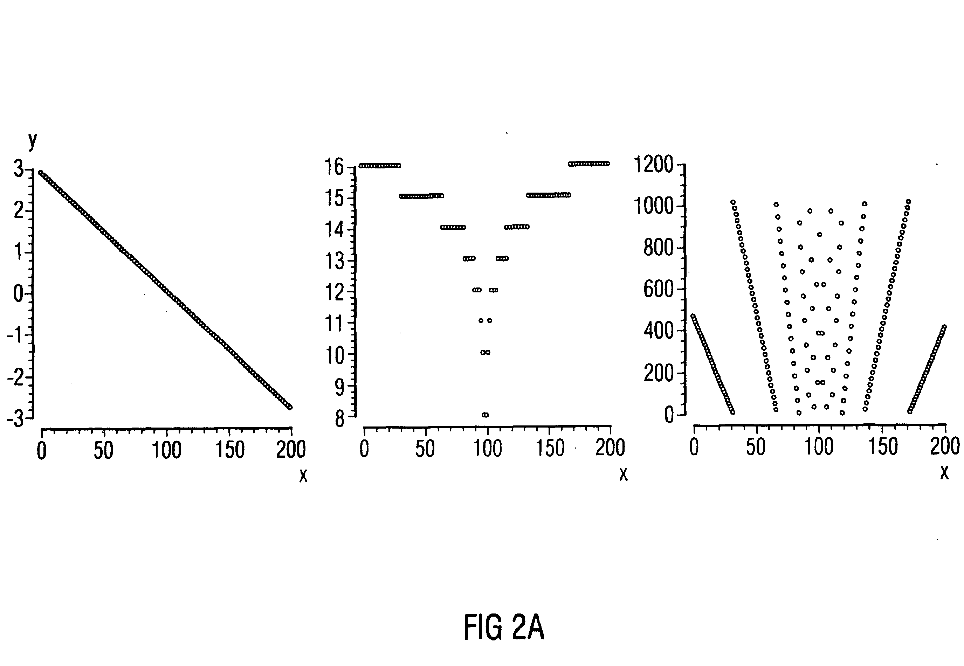

Fig. 2a zeigt eine Zerlegung einer linearen Funktion y (links dargestellt), deren y-Funktionswerte durch 16-Bit Fließkommawerte beschrieben werden, in eine Funktion des Exponenten (in der Mitte dargestellt) und eine Funktion der Mantissenwerte (rechts dargestellt), jeweils als Funktion eines x-Wertes dargestellt. Jedem Wert der linearen Funktion ist somit ein Exponentenwert und ein Mantissenwert zugeordnet, die dann einzeln in Graphen als Funktionen von x dargestellt wurden. Es ist ersichtlich, dass sich die Exponenten nur wenig ändern bzw. nur in der Umgebung, an dem die lineare Funktion den Null-Wert (um x = 100) aufweist, eine starke Änderung aufweisen. Ansonsten sind die Exponentenwerte immer stückweise konstant. Andererseits weisen die Mantissenwerte (rechts dargestellt) eine starke Abhängigkeit von dem jeweiligen x-Wert auf. Insbesondere zeigt die Darstellung der Mantissenwerte ein stark ausgebildetes chaotisches Verhalten in der Nähe des Wertes x = 100. Dieses stark ausgebildete chaotische Verhalten (sehr hohe Entropie) ist zu den häufig ändernden Exponenten korreliert. Es ist klar ersichtlich, dass zwischen den Exponenten und den Mantissenwerten eine Korrelation besteht, d.h. in den Regionen, in denen sich die Exponenten wenig oder kaum ändern, zeigen auch die Mantissenwerte ein reguläres oder monotones Verhalten.

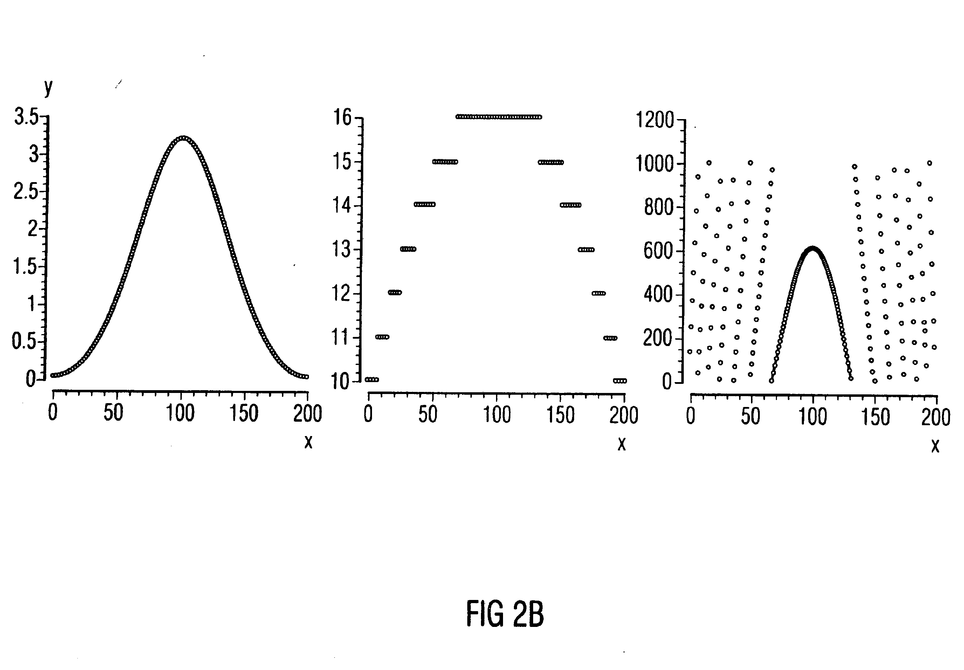

Fig. 2b zeigt ein weiteres Beispiel, wobei diesmal eine Gauss-Kurve links gezeigt ist und zwar in einem Bereich zwischen x = 0 und x = 200. In der Mitte der Fig. 2b ist wiederum eine Darstellung angegeben, die den Exponentenwerten der Gauss-Kurve links entspricht und rechts ist eine Darstellung angegeben, in der die Mantissenwerte dargestellt sind. Es zeigt sich wiederum, dass in der Nähe des Nullpunktes der Gauss-Kurve (y ≈ 0), d.h. in der Nähe von x=0 oder x=200 die Exponenten häufig ändern und dementsprechend die Mantissen eine sehr hohe Entropie aufweisen. Andererseits ist in der Nähe des Extremums der Gauss-Kurve, d.h. in der Nähe des Punktes x=100, der Exponent konstant und dementsprechend ändern sich auch die Mantissenwerte nur geringfügig.

Aus Fig. 2a, b ist eindeutig ersichtlich, dass das Verhalten der Mantisse äußerst sprunghaft ist und in direkter Abhängigkeit zum Exponenten steht. Dieses starke Sprungverhalten der Mantisse stellt das oben beschriebene grundsätzliche Problem bei der Kompression von Fließkommazahlen, da Vorhersagen (beispielsweise im Rahmen einer Entropie-Codierung) in den seltensten Fällen zutreffen. Eine Nutzung der Korrelation von Exponent und Mantisse mittels einer kontextbasierten Mantissenvorhersage ist mit deutlichen Bitraten-Gewinnen verbunden.

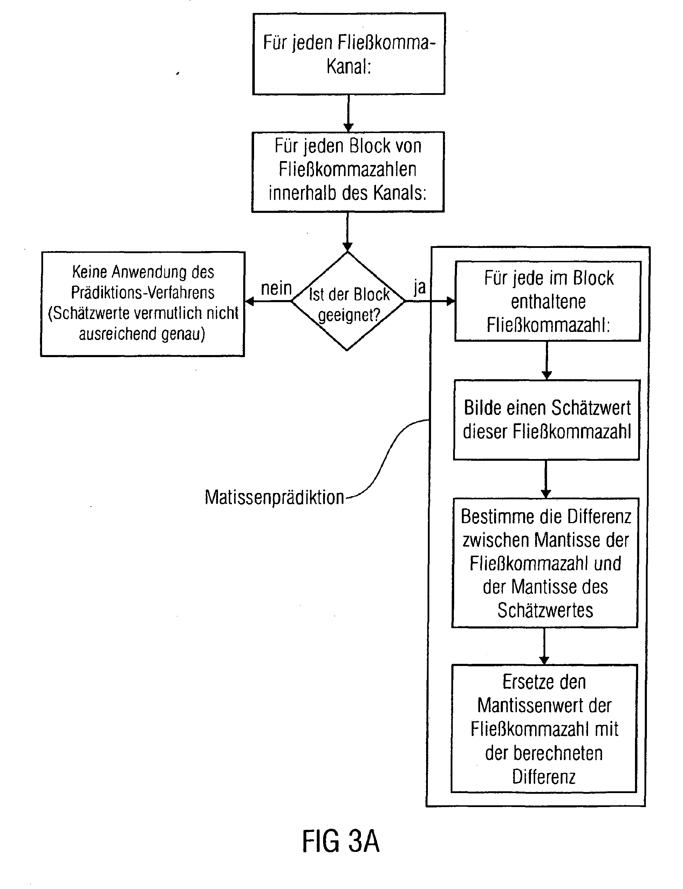

Fig. 3a zeigt ein vereinfachtes Blockdiagramm (ohne arithmetische Codierung) für eine Schrittfolge eines möglichen Verfahrens gemäß einem Ausführungsbeispiel. Dabei wird für jeden Fließkomma-Kanal, d.h. z.B. für die rote Farbe, blaue Farbe und grüne Farbe, und für jeden Block von Fließkommazahlen innerhalb des Kanals zunächst festgestellt, ob der jeweilige Block für eine Mantissenprädiktion geeignet ist. Sofern dies nicht der Fall ist, erfolgt kein Prädiktionsverfahren, da der Schätzwert vermutlich keine ausreichende Genauigkeit ausweisen würde. Wenn jedoch der Block geeignet ist, erfolgt die Mantissenprädiktion, d.h. für jede Fließkommazahl in dem jeweiligen Block wird ein Schätzwert dieser Fließkommazahl gebildet. Daran anschließend wird die Differenz zwischen der Mantisse der Fließkommazahl und der Mantisse des Schätzwertes bestimmt. Zum Schluss wird der Mantissenwert der Fließkommazahl mit der berechneten Differenz ersetzt.

Von zentraler Bedeutung ist die auf den Exponentenwerten des Blocks basierende Entscheidung, ob der Block für eine Mantissenprädiktion geeignet bzw. ungeeignet ist. Dies stellt sicher, dass lediglich jene Blöcke der Prädiktion unterzogen werden, die für einen Einsatz des Prädiktionsverfahrens vorteilhaft erscheinen. Die Eignung eines Blocks für die Mantissenprädiktion richtet sich beispielsweise danach, ob in dem jeweiligen Block die Exponenten eine große Variation aufweisen, oder ob die Exponenten weitestgehend konstant sind. Ein Kriterium könnte beispielsweise sein, dass innerhalb des Blockes die Exponenten nur um einen vorbestimmten Wert schwanken (z.B. um $\pm 1$ oder $\pm 2$ oder $\pm 3$ oder $\pm 4$ Größenordnungen) oder alternativ, dass die Standartabweichung der Exponenten unterhalb eines vorbestimmten Schwellenwertes liegen, z.B. dass $\delta e/e_m < 0,1$ gilt, wobei $\delta e$ die Schwankungen und $e_m$ ein Mittelwert der Exponenten darstellt.

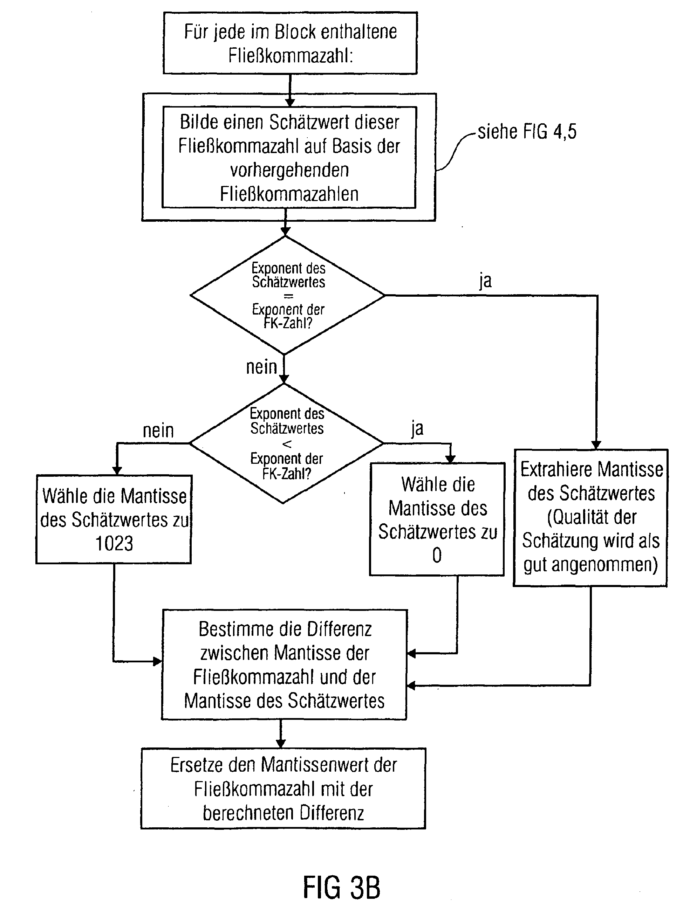

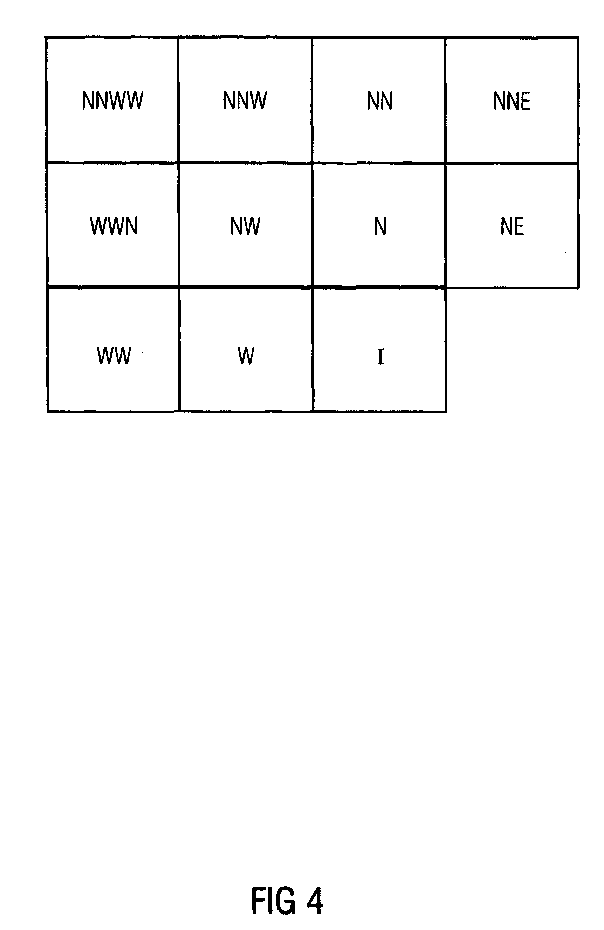

Fig. 3b zeigt ein detailliertes Blockdiagramm für die Mantissenprädiktion, die durchgeführt wird, wenn der Block geeignet ist. Dabei wird der Schätzwert der Fließkommazahl auf der Basis der vorhergehenden Fließkommazahlen bestimmt, wobei die vorhergehenden Fließkommazahlen nicht nur den unmittelbaren Vorgänger umfassen können, sondern auch weiter zurückliegende Fließkommazahlen einbezogen werden können (siehe auch Fig. 4). Nach der Bildung des Schätzwertes wird der Exponent des Schätzwertes mit dem Exponenten der Fließkommazahl verglichen, sofern beide übereinstimmen, wird die Mantisse des Schätzwertes extrahiert, da die Qualität der Schätzung als gut angenommen gilt. Anschließend wird die Differenz zwischen der Mantisse der Fließkommazahl und der Mantisse des Schätzwertes gebildet.

Sofern der Exponent des Schätzwertes jedoch nicht mit dem Exponenten der Fließkommazahl übereinstimmt wird, wenn der Exponent größer ist als der Exponent der Fließkommazahl, so wird die Mantisse des Schätzwertes beispielsweise zu 1.023 gewählt (= maximal mögliche Mantisse, wenn z.B. die Mantisse mit 10 Bit codiert wird). Die so gewählte Mantisse wird genutzt, um die Differenz zwischen der Mantisse der Fließkommazahl und der Mantisse des Schätzwertes zu bilden. Sofern der Exponent des Schätzwertes jedoch kleiner ist als der Exponent der Fließkommazahl wird die Mantisse zu dem Schätzwert 0 (= minimal mögliche Mantisse) gewählt. Die so gewählte Mantisse wird zur Bestimmung der Differenz zwischen der Mantisse der Fließkommazahl und der Mantisse des Schätzwertes genutzt. Als letzter Schritt wird der Mantissenwert der Fließkommazahl mit dem berechneten Differenzwert ersetzt.

Bei den durchgeführten Verfahren wird somit lediglich die Mantisse geschätzt und durch den Restwert ersetzt - der Exponent brauch nicht geändert zu werden, da der Exponent in vielen Fällen bereits gut für die Kompression geeignet ist.

Bei diesem Verfahren dienen die zu treffenden Entscheidungen zur Einschätzung, von welcher Qualität die Schätzungen sind. Hierzu wird die Nichtlinearität der IEEE 754 Fließkommazahlen genutzt: Falls die beiden Exponenten nicht übereinstimmen, kann die geschätzte Mantisse grundsätzlich keine Annäherung an die tatsächliche Mantisse sein. Sie ist damit eine grobe Fehlschätzung und führt mit hoher Wahrscheinlichkeit zu großen Mantissen-Restwerten (Residuals). Allerdings kann hier mit gezielten Maßnahmen eine deutliche Verbesserung der Qualität der Schätzung erreicht werden. Bei einer Analyse der beobachteten Fehlschätzungen zeigt sich, dass sich in vielen Fällen der geschätzte Exponent nur um ±1 (innerhalb eines Blocks) vom tatsächlichen Exponent unterscheidet. Dies bedeutet, dass die durch das IEEE 754 Format repräsentierte Fließkommazahl ihren durch den Exponenten vorgegebenen Wertebereich verlassen hat, sich mit hoher Wahrscheinlichkeit aber immer noch nahe an dessen Grenzen befindet. Ein um beispielsweise 1 kleinerer Schätzexponent besitzt deshalb mit hoher Wahrscheinlichkeit eine Mantisse, die sich im oberen Wertebereich (nahe 1023) befindet. Der tatsächliche Mantissenwert sollte daher den unteren Wertbereich (nahe 0) einnehmen, da sich der zugehörige Exponent um 1 über dem geschätzten Exponent befindet. Ähnliches gilt für um 1 höheren Schätzexponenten. Dieser Zusammenhang lässt sich nutzen, um bei Schätzwerten mit unterschiedlichen Exponenten (schlechte Schätzung) die Qualität der Schätzung zu steigern. In anderen Worten wird bei abweichenden Exponenten die Mantisse entweder auf den Maximalwert gesetzt, wenn Exponent der Fließkommazahl größer ist als der Exponent der Schätzwert, oder auf den Minimalwert gesetzt, wenn Exponent der Fließkommazahl kleiner ist als der Exponent der Schätzwert. Es zeigt sich, dass mit dieser Methode die aus den Fehlschätzungen resultierenden großen Mantissensprünge deutlich reduziert bzw. ganz vermieden werden können.

Das beschriebene Verfahren zur Bildung des Schätzwertes wird lediglich durch einen einzigen Block repräsentiert ("Bilde einen Schätzwert dieser Fließkommazahl auf Basis der vorhergehenden Fließkommazahlen"). Dieses Verfahren soll im Folgenden näher betrachtet werden. Grundsätzlich erfüllt das Verfahren den Zweck, einen Fließkommawert auf Basis der umgebenden Fließkommawerte mit möglichst hoher Güte vorherzusagen. Im Folgenden ist daher auch von Extrapolation eines Fließkommawertes auf Basis der benachbarten Fließkommawerte die Rede.

Fig. 4 gibt eine schematische Darstellung der Nachbarschaft der vorbestimmten Fließkommazahl oder eines vorbestimmten Fließkommawertes I, wobei die Nachbarschaft sich auf zuvor bestimmte oder codierte Fließkommawerte bezieht. Bei dem hier gezeigten Ausführungsbeispiel wird davon ausgegangen, dass beispielsweise ein zweidimensionales Bild codiert werden soll, indem eine zeilenförmige Abtastung von oben nach unten und von links nach rechts erfolgt. Die Nachbarschaft des vorbestimmten Fließkommawertes I, der geschätzt werden soll, wird nun nach Himmelsrichtungen unterteilt, wobei die nördliche Richtung der vertikalen Richtung des beispielhaften Bildes entspricht und die westliche Richtung der nach links zeigenden horizontalen Richtung des Bildes. Die nördliche Richtung als auch die westliche Richtung beziehen sich dabei auf Richtungen, die entgegen der Scanrichtung liegen, wobei sich die Scanrichtung auf das beispielhafte zeilenförmiges Abtasten (scannen) eines zweidimensionalen Bildes bezieht. Neben der nördlichen Richtung N und der westlichen Richtung W wird weiterhin nach einer nordwestlichen Richtung NW und einer nordöstlichen Richtung NE unterschieden. Die jeweils übernächsten Nachbarn sind dementsprechend in nördlicher Richtung die Nachbarn Nord-Nord NN, in rein westlicher Richtung die Nachbarn West-West WW und in nordwestlicher Richtung der Nachbar Nord-Nord-West-West NNWW (von I aus gesehen: 2 Mal Richtung Nord und 2 Mal Richtung West). Dieses Muster kann entsprechend fortgesetzt werden, um weitere Nachbarn einzubeziehen. Jedes Quadrat entspricht dabei einem Farbwert eines Pixels (z. B. Rot, Grün oder Blau) in dem beispielhaften Block.

Fig. 4 zeigt somit die Nachbarschaftswerte, die in die Schätzung einbezogen werden (I markiert den zu schätzenden Fließkommawert) und das Verfahren berechnet die lokalen Gradienten in vier Richtungen: horizontal (West), 45° (Nordwest), vertikal (Nord) und 135° (Nordost) und bestimmt jene Richtung, deren Gradient am kleinsten ist.

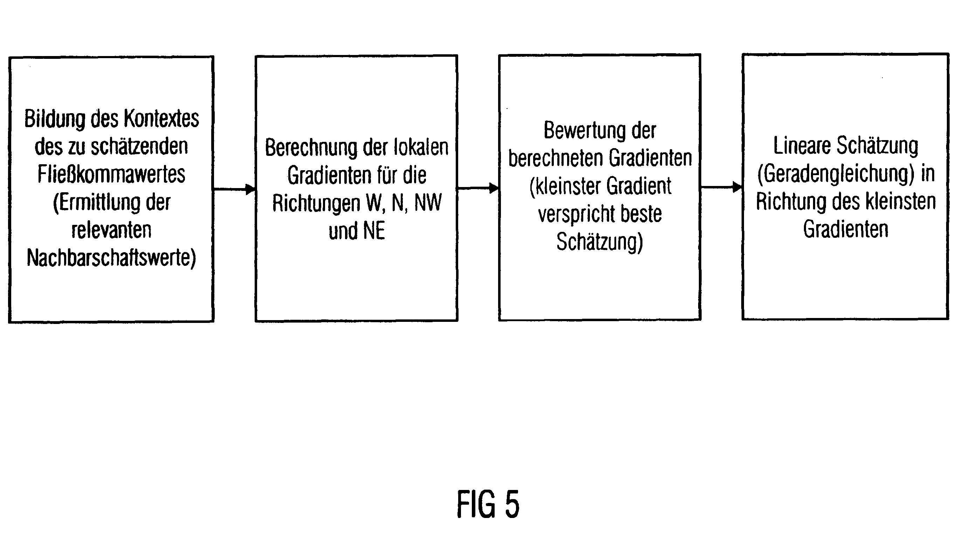

Fig. 5 zeigt eine schematische Darstellung für die Prozesskette zur Bildung des Schätzwertes in der Mantissenprädiktion in Form eines Blockdiagramms. Dabei werden zunächst die relevanten Nachbarschaftswerte zu dem zu schätzenden Wert ermittelt, wodurch sich der Kontext des zu schätzenden Fließkommawertes definiert. Als nächstes werden die lokalen Gradienten in den Richtungen West W, Nord N, Nordwest NW und Nordost NE bestimmt. Nach Bestimmung der lokalen Gradienten in der Nachbarschaft der vorbestimmten Fließkommazahl I erfolgt eine Bewertung der berechneten Gradienten und zwar dahingehend, dass der kleinste Gradient die beste Schätzung verspricht (z.B. entlang einer Kontur).

Diese Vorgehensweise basiert auf der Annahme, dass Richtungen mit hohen Gradienten Kanten im Bild signalisieren und dadurch ungeeignet für Schätzwertbildungen sind. Die Richtung des kleinsten Gradienten hingegen zeigt vermutlich in Richtung der örtlichen Textur, was die Bildung eines guten Schätzwertes fördert. Die Gradienten können beispielsweise wie folgt berechnet werden:

$$d_w = floor(2*|W{-}WW|+2*|N{-}NW|+2*|NW{-}WWN|+2*|N{-}NE|+$$
$$|NN{-}NNW|+|NN{-}NNE|)/10 + 0,5);$$

$$d_n = floor(2*|N-NN|+2*|W-NW|+2*|NW-NNW|+2*|NE-NNE|+$$
$$|WW-WWN|+|WWN-NNWW|)/10 + 0,5);$$

$$d_{nw} = floor(2*|W-WWN|+2*|N-NNW|+|NW-NNWW|+|NE-NN|)/6+0,5);$$

$$d_{ne} = floor(2*|WW-NW|+2*|N-NNE|+W-N|+|NW-NN|)/6 + 0,5).$$

Schließlich erfolgt eine lineare Schätzung oder eine lineare Extrapolation, die mittels einer Geradengleichung in der Richtung des kleinsten Gradienten erfolgen kann. Die Nutzung des kleinsten Gradienten ist ferner vorteilhaft, da Exponentenwechsel minimiert werden können. Auf diese Weise wird für die betrachtete Position I ein Fließkommawert ermittelt, der mit hoher Wahrscheinlichkeit die gute Schätzung des tatsächlichen Wertes an der Stelle I darstellt.

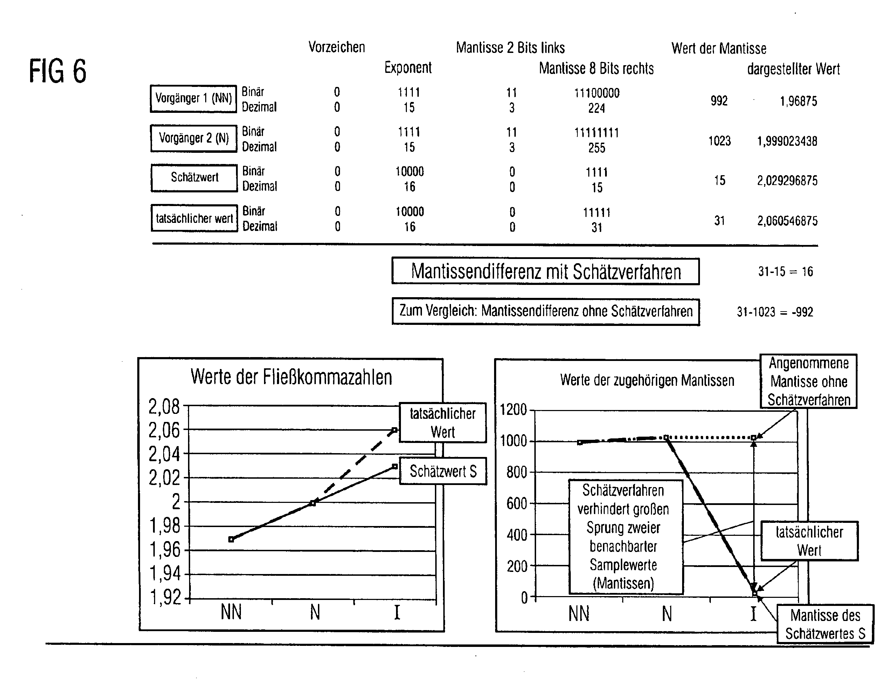

Fig. 6 zeigt nachfolgend ein einfaches Zahlenbeispiel, um die Funktionsweise des Prädiktionsverfahrens zu verdeutlichen. Es repräsentiert den Ablauf der Blockdiagramme in Fig. 3b für den Fall, dass der Exponent der geschätzten Fließkommazahl dem Exponenten der tatsächlichen Fließkommazahl entspricht (also die Schätzung als gut angenommen wird). Die Richtung des kleinsten Gradienten innerhalb der Nachbarschaft wird als vertikal (nördlich) angenommen. Daraus folgt, dass für die Bildung des Schätzwertes die Nachbarschaftswerte an den Stellen NN (Nord-Nord) und N (Nord) selektiert werden. Die dazugehörigen Fließkommazahlen wurden exemplarischen zu 1,96875 und 1,999023438 gewählt. Die nachfolgende Fließkommazahl, deren Wert geschätzt werden soll, beträgt im vorliegenden Beispiel 2,060546875. Würde man eine Entropiecodierung der Mantisse ohne vorhergehendes Prädiktionsverfahren durchführen, ergäbe sich zwischen der zweiten und der dritten Zahl ein enormer Sprung in den Mantissenwerten, da die dritte Zahl einen um 1 erhöhten Exponenten besitzt.

Konkret zeigt Fig. 6 im unteren Teil zunächst auf der linken Seite die Werte der Fließkommazahlen, wobei der Wert auf der Nord-Nord-Position 1,96875 und der Wert auf der Nordposition 1,999023438 entspricht. Aus diesen beiden Werten kann jetzt eine lineare Extrapolation erfolgen, so dass der Schätzwert einen Wert aufweist von 2,029296875, der von dem tatsächlichen Wert 2,060546875 nur geringfügig abweicht. Dazu wird eine Geradengleichung durch die ersten beiden Zahlen aufgestellt und auf dieser Grundlage der dritte Wert geschätzt: 2,029296875. Insbesondere liefert der Schätzwert bereits die Überschreitung einer neuen Potenz, so dass der Mantissenwert des Schätzwertes von dem Mantissenwert des tatsächlichen Wertes geringfügig abweicht und zwar um einen Wert 16 (Mantissendifferenz mit Schätzverfahren), wie aus der Darstellung oben in der Fig. 6 ersichtlich ist.

Im Detail zeigt die Darstellung oben in der Fig. 6 links eine Bezeichnung der Fließkommawerte, d.h. der Vorgänger 1 in NN-Richtung, der Vorgänger 2 in Nordrichtung, der Schätzwert und der tatsächliche Wert sind übereinander angeordnet. In der ersten Spalte sind die Vorzeichen gezeigt (z. B. alle positiv -> 0), es folgt der Exponent, wobei die erste Zahl den entsprechenden binären Code zeigt (mit 5 Bit codiert) und der zweite Wert den entsprechenden Dezimalwert angibt. Das heißt der Vorgänger 1 hat einen Exponenten von 15 und der tatsächliche Wert von 16. In der dritten Spalte bzw. vierten Spalte findet sich die Angabe des Mantissenwertes in binärer Form. Der Mantissenwert ist zweigeteilt angegeben, mit den zwei höchstwertigen Bits in der dritten Spalte und den nachfolgenden 8 niederwertigen Bits in der vierten Spalte. Die vorletzte Spalte enthält den dezimalen Wert, der durch die 10-Bit-Mantisse dargestellt wird. Schließlich ist in der letzten Spalte ganz rechts der dargestellte Wert angegeben.

Der Vorteil des erfindungsgemäßen Verfahrens zeigt sich in der Mantissendifferenz, die bei der Verwendung des Schätzwertes lediglich 16 beträgt (31-15), währenddessen die Mantissendifferenz ohne Schätzverfahren, d.h. die Differenz des Mantissenwertes der vorbestimmten Fließkommazahl und des Mantissenwertes des Vorgängers 2 insgesamt -992 (=31-1.023)beträgt. Dieser hohe Sprung der Mantissendifferenz bei Weglassen des Schätzverfahrens ist ebenfalls in der Fig. 6 unten rechts gezeigt. Hier wird auch ersichtlich, dass der Schätzwert (mit "o" markiert) bereits nahe an dem tatsächlichen Wert (mit "x" markiert) liegt, so dass das Schätzverfahren einen großen Sprung benachbarter Samplewerte in den Mantissen verhindert.

Der Einsatz des Prädiktionsverfahrens ermöglicht die weitestgehende Unterdrückung der auftretenden Mantissensprünge. Ein Blick auf den Exponenten der Schätzung (16) zeigt, dass dieser um 1 gegenüber dem Exponenten der Nachbarn (15) erhöht ist, also mit einer stark springenden Mantisse gerechnet werden muss. Da der Exponent der Schätzung aber auch gleichzeitig mit dem Exponenten der dritten (= zu schätzenden Zahl) übereinstimmt, ist der Schätzwert der Mantisse als hinreichend gut anzunehmen. Er wird daher für die Differenzwertbildung benutzt. Tatsächlich ergibt sich nun eine Differenz von lediglich 31-15=16 Mantissenstufen, der große Sprung um 992 Stufen bei Nichtanwendung des Prädiktionsverfahrens konnte so vermieden werden.

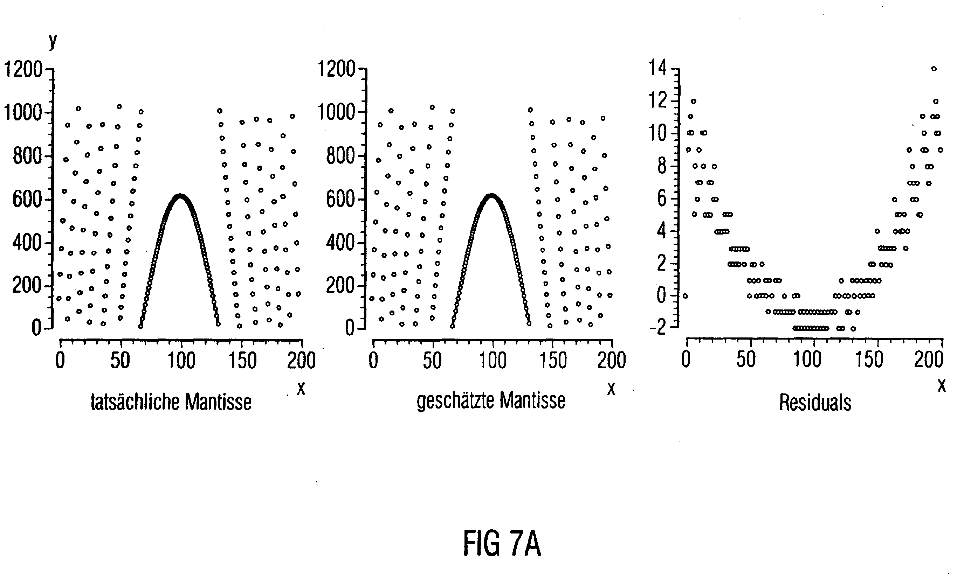

Die Figuren 7a bis 7c veranschaulichen das Potenzial der beschriebenen Mantissenprädiktion. Die Fig. 7a ist hier als theoretisches Beispiel aufgeführt (siehe Gausskurve in Fig. 2b), alle anderen Ergebnisse beziehen sich auf reale Fließkomma-Bilder im HALF-Format.

In der Fig. 7a sind zunächst die tatsächlichen Mantissenwerte für die Gauss'sche Kurve gezeigt (links) und in der Mitte die geschätzte Mantisse für die Gauss'sche Kurve, so dass sich rechts die Differenz der beiden Darstellungen als Residuals (Restwerte) ergibt. Es ist klar ersichtlich, dass die Residuals in einem Wertebereich zwischen +14 und -2 variieren, währenddessen die tatsächlichen Mantissenwerte in einem Wertebereich zwischen 0 und 1023 variieren. Die Schwankungsbreite der entsprechenden Werte hat sich somit um einen Faktor von nahezu 70 verringert, so dass sich die Residuals, so wie sie in der Figur rechts dargestellt sind, deutlich besser für eine Komprimierung beispielsweise mittels einer Entropiecodierung eignen.

Fig. 7a zeigt somit den Idealfall: Eine extrem sprunghafte Mantisse, welche sich für eine Entropiecodierung in keinster Weise eignet, wird mittels Prädiktion auf einen relativ stetigen Verlauf gemappt (zu beachten sind die Wertebereiche der tatsächlichen Mantisse und der Residuals). Die Mantissen-Restwerte (=Residuals) zeigen bei einer Entropiecodierung deutliche Vorteile gegenüber den tatsächlichen Mantissen.

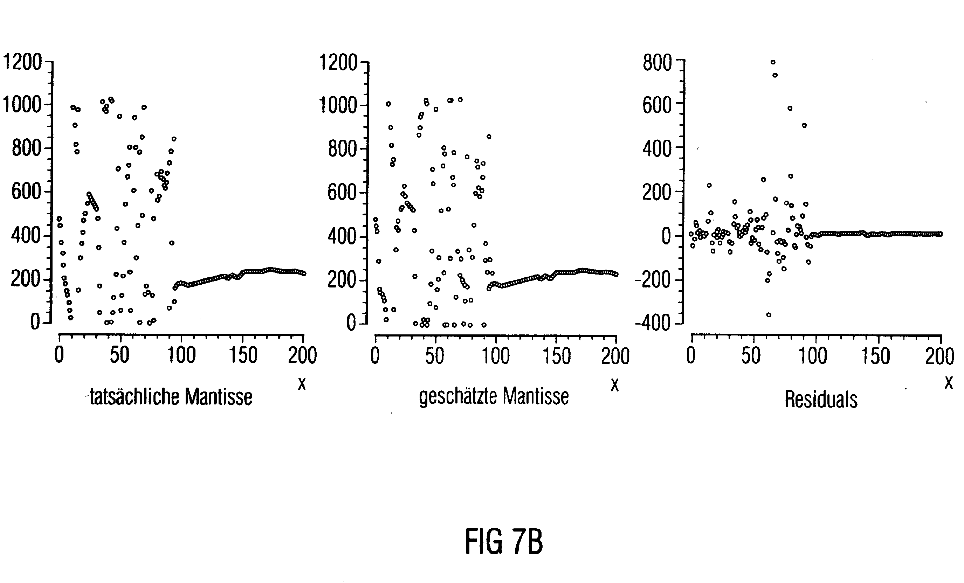

Fig. 7b zeigt ein weiteres Beispiel, wobei links wiederum ein tatsächlicher Mantissenwert, in der Mitte der geschätzte Mantissenwert und rechts wiederum die nach der Differenzbildung erhaltenen Restwerte angegeben sind. Die Betrachtung der unterschiedlichen Wertebereiche zeigt eine deutlich reduzierte Schwankungsbreite der für die Codierung genutzten Mantisse (z. B zwischen x = 0 ... 50).

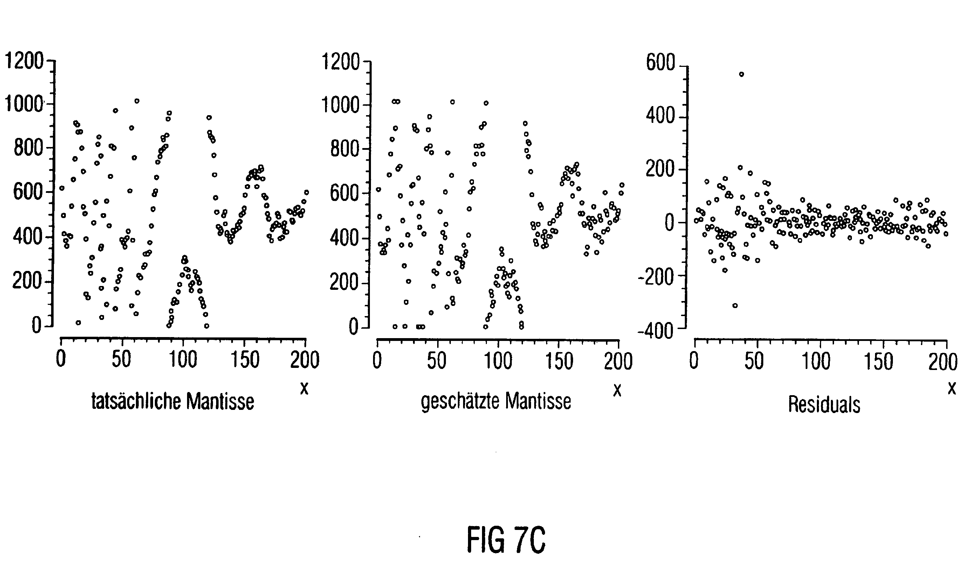

Fig. 7c zeigt schließlich ein drittes Beispiel, wobei wiederum links der tatsächliche Mantissenwert, in der Mitte der geschätzte Mantissenwert und rechts der entsprechende Rest-Mantissenwert, der sich nach der Differenzbildung zwischen dem tatsächlichen und dem geschätzten Mantissenwert ergibt, angegeben ist. Bei diesem Beispiel zeigt sich eine deutliche Verbesserung gegenüber dem tatsächlichen Mantissenwert über den gesamten Bereich zwischen x=0 bis x=200.

Die Fig. 7b und 7c zeigen die Ergebnisse für Fließkommazahlen aus HDR-Bildern. Als Sample-Werte wurden die ersten 200 Helligkeitswerte (x zählt somit die Samplewerte) des Kanals Grün verwendet. Man erkennt in beiden Abbildungen deutlich, dass Bereiche mit heftigen Mantissensprüngen gedämpft werden (linker Bereich in Fig. 7b, gesamter Bereich in Fig. 7c).

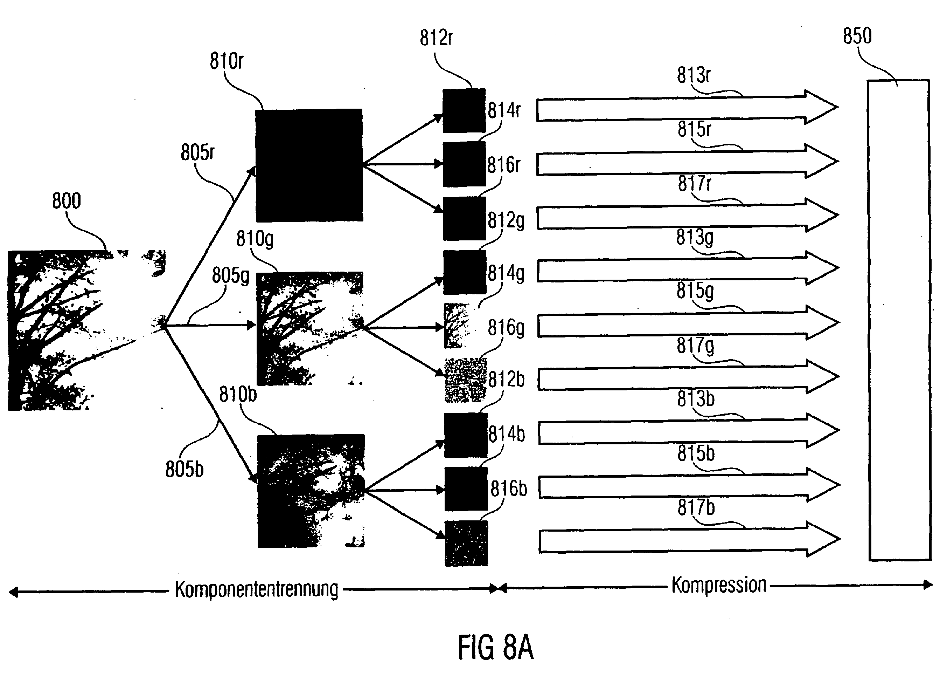

Die Fig. 8a zeigt eine mögliche Architektur einer konventionellen JPEG2000 Codierung mit einem Fließkomma-Kompressor, der eine separate Behandlung des Vorzeichens, des Exponenten und der Mantisse erlaubt.

Der Fließkomma-Kompressor, sowie er in der Fig. 8a gezeigt ist, wird dabei in eine Komponententrennung und in eine Kompression unterteilt. Bei der Komponententrennung wird zunächst ein Bild 800 in die roten Komponenten 805r, die grünen Komponenten 805g und die blauen Komponenten 805b zerlegt, so dass sich ein rotes Bild 810r, ein grünes Bild 810g und ein blaues Bild 810b ergibt. Jede Komponente besteht aus einer Vielzahl von Helligkeitswerten, welche durch Fließkommawerte repräsentiert werden. Jeder Fließkommawert wiederum wird in ein Vorzeichen, einen Exponenten und eine Mantisse zerlegt. Dementsprechend ergibt sich für das rote Bild ein Vorzeichenbild 812r, ein Exponentenbild 814r und eine Mantissenbild 816r. Für das grüne Bild 810g ergibt sich ebenfalls ein Vorzeichenbild 812g, ein Exponentenbild 814g und eine Mantissenbild 816g. Schließlich ergibt sich auch für das blaue Bild 810b ein Vorzeichenbild 812b, ein Exponentenbild 814b und ein Mantissenbild 816b. Jedes der Bilder ist durch eine Vielzahl von Bildpunkten gegeben.

Nachdem das ursprüngliche Bild 800 derart in insgesamt neun Komponenten zerlegt wurde, erfolgt eine Kompression 813, 815, 817 um einen Datenstrom 850 von codierten Bilddaten zu erhalten. Die Vorzeichenwerte 812r,g,b können dabei direkt beispielsweise durch eine Entropiecodierung 813r,g,b komprimiert werden. Bei den Exponentenwerten 814r,g,b kann während der Kompression 815r,g,b ein DC-Levelshift, eine Wavelet-Transformation ausgeführt und schließlich beispielsweise durch eine Entropiecodierung komprimiert werden. Der DC-Levelshift dient dabei der Umwandlung der eigentlich vorzeichenlosen Größen in vorzeichenbehaftete Größen. Der DC-Levelshift kann beispielsweise mittels einer Subtraktion des halben Wertebereichsmaximums von der betrachteten Größe realisiert werden. Die Mantissenwerte 816r,g,b sind jedoch wie oben beschrieben, für eine Wavelet-Transformation ungeeignet (in Folge der hohen Entropie), sie werden daher während der Komprimierung 817r,g,b direkt einer Entropiecodierung unterzogen. Die aus diesen neun Kanälen erhaltenen Daten werden schließlich in einem Datenstrom 850 angeordnet, wobei der Datenstrom 850 eine konventionelle Datenstruktur wie unter JPEG2000 aufweisen kann.

Da bei diesem Verfahren das Vorzeichen, der Exponent und die Mantisse separat behandelt werden, eignet sich dieses Verfahren für die zusätzliche Anwendung der erfindungsgemäßen kontextbasierten Mantissenprädiktion.

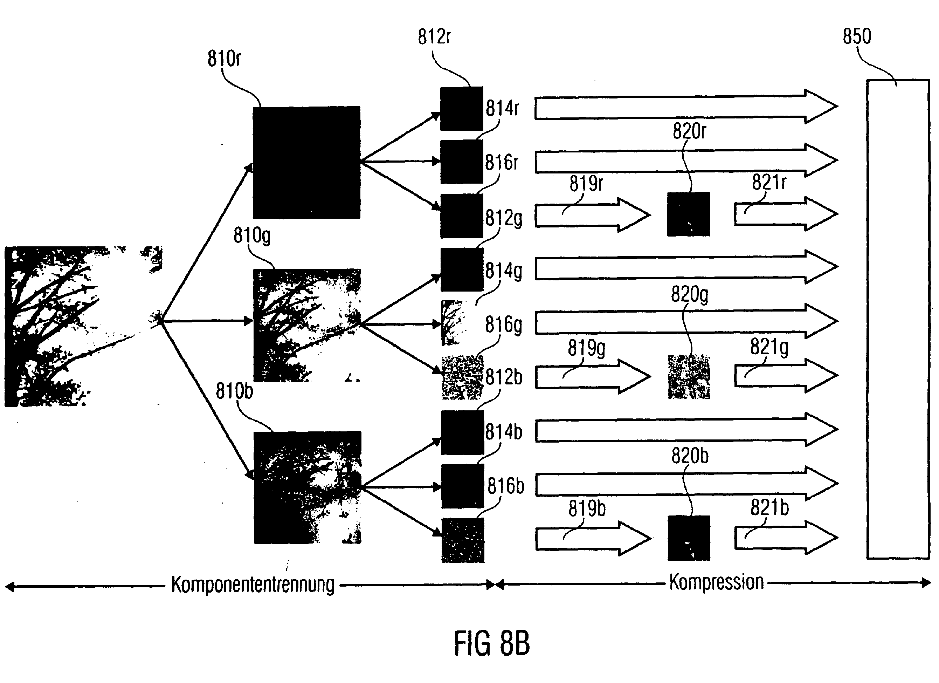

Fig. 8b zeigt ein weiteres Ausführungsbeispiel für die zusätzliche Anwendung der Mantissenprädiktion. Dabei wird die Kompression 817r,g,b der Mantissenwerte 816r,g,b dadurch modifiziert, dass zunächst ein Prädiktionsverfahren 819r,g,b gemäß Ausführungsbeispielen durchgeführt wird, wobei während des Prädiktionsverfahrens 819r,g,b wie oben beschrieben, die Mantissenwerte durch Mantissen-Restwerte (Differenzmantissen) ersetzt werden, die sich durch die Abweichung der Mantissenwerte 816r,g,b zu den entsprechenden Schätzwerten ergeben.

Somit wird beispielsweise für das rote Bild 810r für die Mantissenwerte 816r zunächst ein Prädiktionsverfahren 819r durchgeführt, welches ein modifiziertes Mantissenbild 820r (jedem Pixelwert des Bildes ist die Abweichung des ursprünglichen Mantissenwertes von dem geschätzten Mantissenwert zugeordnet) ergibt. Daran anschließend kann dies so erhaltene modifizierte Mantissenbild 820r durch eine Entropiecodierung 821r beispielsweise komprimiert werden und in den Datenstrom 850 zugeführt werden. Analog können die Mantissenwerte 816g des grünen Teilbilds 810g ebenfalls zunächst im Rahmen eines erfindungsgemäßen Prädiktionsverfahrens 819g verändert werden, so dass sich wiederum ein modifiziertes grünes Mantissenbild 820g ergibt, welches schließlich beispielsweise durch eine Entropie-Komprimierung 821g komprimiert werden kann und dem Datenstrom 850 zugeführt wird. Analog wird das blaue Teilbild 810b dahin gehend für eine Kompression verbessert, dass die Mantissenwerte 816b zunächst in einem Prädiktionsverfahren 819b modifiziert werden, so dass sich das modifizierte Mantissenbild 820b ergibt, welches wiederum beispielsweise durch eine Entropiecodierung 821b komprimiert werden kann. Alle anderen Verfahrensschritte unterscheiden sich nicht von den in der Fig. 8a gezeigten Verfahrensschritten, so dass sich die Komprimierung oder die Behandlung der Vorzeichenwerte 812 und die Behandlung der Exponentenwerte 814 nicht unterscheiden.

Die Fig. 8b zeigt also einen möglichen Einsatz des erfindungsgemäßen Prädiktionsverfahrens für die Mantissenwerte in eine bestehende Kompressorarchitektur.

Bei weiteren Ausführungsbeispielen kann, neben einer Mantissenprädiktion auch eine Exponenten-Prädiktion durchgeführt werden, so dass auch die Exponenten durch die Differenzwerte (Differenz zwischen geschätztem und tatsächlichem Exponenten) ersetzt werden. Das kann insbesondere dann sinnvoll sein, wenn sich Blöcke nicht zur Mantissenprädiktion eignen.

Zusammenfassend lassen sich die Vorteile von Ausführungsbeispielen im Vergleich zu konventionellen Verfahren wie folgt darstellen. Beispiele für konventionelle Verfahren sind die zwei eng miteinander konkurrierenden verlustlosen Kompressionsverfahren für HDR-Bildmaterial: HD Photo und PIZ. Beide liefern im Schnitt Kompressionsverhältnisse von 1,7:1; dies stellt momentan die obere Grenze des technisch Machbaren dar. Wünschenswert wären jedoch Verhältnisse von 2:1 und höher, wie es im Bereich der Integerbild-Kompression mit Verfahren wie JPEG2000 bereits erreicht wird. Das grundsätzliche Problem aller konventionellen Fließkomma-Kompressionsverfahren ist, dass die Nichtlinearität der IEEE 754 Standards eine hohe Entropie der Mantissenwerte nach sich zieht, was sich wiederum negativ bei einer arithmetischen Codierung bemerkbar macht. Das in diesem Dokument beschriebene Verfahren nutzt eine bislang unberücksichtigte Korrelation von Exponent und Mantisse, um die Entropie der Mantissenwerte zu reduzieren. Durch die Mantissenprädiktion werden bei der Kompression (eine effiziente arithmetische Codierung vorausgesetzt) merkliche Kompressionsgewinne erzielt.

Wenn auch die meisten Ausführungsbeispiele effiziente Bildcodierungen mittels Fließkommawerten umfassen, so ist das erfindungsgemäße Konzept gleichermaßen auch für andere Anwendungen anwendbar. Zum Beispiel können auch Videodaten durch Fließkommawert codiert werden, so dass Ausführungsbeispiele sich ebenfalls auf solche Anwendungen beziehen.

Zusammenfassend beziehen sich Ausführungsbeispiele der vorliegenden Erfindung auf eine Vorrichtung und ein Verfahren zur Codierung und Decodierung einer Mehrzahl von Fließkommawerten (F) mittels kontextbasierter Vorhersage der enthaltenen Mantissenwerte. Die Erfindung ist in der Lage, das starke Sprungverhalten der Mantissen typische Fließkommawerte zu dämpfen und eine effiziente Codierung zu ermöglichen.

Insbesondere wird darauf hingewiesen, dass abhängig von den Gegebenheiten das erfindungsgemäße Schema auch in Software implementiert sein kann. Die Implementierung kann auf einem digitalen Speichermedium, insbesondere einer Diskette oder einer CD mit elektronisch auslesbaren Steuersignalen erfolgen, die so mit einem programmierbaren Computersystem zusammenwirken können, dass das entsprechende Verfahren ausgeführt wird. Allgemein besteht die Erfindung somit auch in einem Computerprogrammprodukt mit auf einem maschinenlesbaren Träger gespeicherten Programmcode zur Durchführung des erfindungsgemäßen Verfahrens, wenn das Computerprogrammprodukt auf einem Rechner abläuft. In anderen Worten ausgedrückt kann die Erfindung somit als ein Computerprogramm mit einem Programmcode zur Durchführung des Verfahrens realisiert werden, wenn das Computerprogramm auf einem Computer abläuft.

Obige Ausführungsbeispiele beschreiben also unter anderem auch eine Vorrichtung zum Codieren einer Mehrzahl von Fließkommawerten F mit einer Einrichtung zum Extrapolieren 110 von Fließkommawerten F aus einer Nachbarschaft eines vorbestimmten Fließkommawertes der Mehrzahl von Fließkommawerten F, um einen Schätzwert S für den vorbestimmten Fließkommawert I zu erhalten; einer Einrichtung zum Ermitteln 120 eines Mantissen-Restwertes abhängig von einer Differenz der Mantissen des Schätzwertes und der Mantisse des vorbestimmten Fließkommawerts I; und einer Einrichtung zum Codieren 130 des vorbestimmten Fließkommawertes durch Codieren eines Exponenten des vorbestimmten Fließkommawertes F und des Mantissen-Restwerts, wobei die Vorrichtung ferner eine Einrichtung zum Komprimieren 815, 817; 821 aufweisen kann, wobei die Einrichtung zum Komprimieren 815, 817; 821 ausgebildet sein kann, die Mantissen-Restwerte zu komprimieren. Dabei kann die Einrichtung zum Komprimieren 815, 817; 821 einen Wavelet-Transformer aufweisen, wobei der Wavelet-Transformer ausgebildet sein kann, eine Wavelet-Transformation für die Mantissen-Restwerte durchzuführen. Die Einrichtung zum Komprimieren 815, 817; 821 kann ausgebildet sein, die Mantissen-Restwerte in ein Ganzzahlbitmuster zu wandeln und eine Komprimierung für das Ganzzahlbitmuster durchzuführen.

**Patentansprüche**

1. Vorrichtung zum Codieren einer Mehrzahl von Fließkommawerten (F), wobei die Mehrzahl von Fließkommawerten (F) Helligkeitswerten von abzutastenden Bildpunkten entspricht und die Bildpunkte in Blöcke unterteilt sind, wobei jeder Block eine vorbestimmte Anzahl von Bildpunkten aufweist, mit
   einer Einrichtung zum Codieren (130), die ausgebildet ist, um eine Schwankungsbreite der Exponenten der Mehrzahl von Fließkommawerten (F) in den Blöcken zu bestimmen und Blöcke, bei denen die Schwankungsbreite einen Schwellwert für die Schwankungsbreite überschreitet, zu einer Codierung ohne Extrapolation weiterzuleiten;
   einer Einrichtung zum, für Blöcke, bei denen die Schwankungsbreite einen Schwellwert für die Schwankungsbreite nicht überschreitet, Extrapolieren (110) der Fließkommawerte (F) aus einer Nachbarschaft eines vorbestimmten Fließkommawertes der Mehrzahl von Fließkommawerten (F), um einen Schätzwert (S) für den vorbestimmten Fließkommawert (I) zu erhalten; und
   einer Einrichtung zum, für die Blöcke, bei denen die Schwankungsbreite einen Schwellwert für die Schwankungsbreite nicht überschreitet, Ermitteln (120) eines Mantissen-Restwertes abhängig von einer Differenz der Mantisse des Schätzwertes und der Mantisse des vorbestimmten Fließkommawerts (I); und
   wobei die Einrichtung zum Codieren (130) ausgebildet ist, um für die Blöcke, bei denen die Schwankungsbreite einen Schwellwert für die Schwankungsbreite nicht überschreitet, den vorbestimmten Fließkommawert durch Codieren eines Exponenten des vorbestimmten Fließkommawertes (F) und des Mantissen-Restwerts zu codieren.

2. Vorrichtung nach Anspruch 1, die ferner eine Einrichtung zum Extrahieren von Komponentensignalen aufweist, wobei die Komponentensignale eine rote Komponente (810r), eine grüne Komponente (810g) und eine blaue Komponente (810b) aufweisen.

3. Vorrichtung nach Anspruch 1 oder 2, bei der die Einrichtung zum Codieren so ausgebildet ist, dass der Schwellwert $\pm1$ oder $\pm2$ beträgt.

4. Vorrichtung nach einem der vorhergehenden Ansprüche, die ferner eine Einrichtung zum Komprimieren (815, 817; 821) aufweist, wobei die Einrichtung zum Komprimieren (815, 817; 821) ausgebildet ist, die Mantissen-Restwerte zu komprimieren.

5. Vorrichtung zum Decodieren einer Mehrzahl von codierten Fließkommawerten (F'), wobei die Mehrzahl von codierten Fließkommawerten Helligkeitswerten von Bildpunkten entspricht und die Bildpunkte in Blöcke unterteilt sind, wobei jeder Block eine vorbestimmte Anzahl von Bildpunkten aufweist, mit einer Einrichtung zum Decodieren (210), die ausgebildet ist, einen Exponenten der Fließkommawerte (I) zu decodieren und eine Schwankungsbreite der Exponenten der Mehrzahl von Fließkommawerten (F) in den Blöcken zu bestimmen und Blöcke, bei denen die Schwankungsbreite einen Schwellwert für die Schwankungsbreite überschreitet, zu einer Deodierung ohne Extrapolation weiterzuleiten;
   einer Einrichtung zum, für Blöcke, bei denen die Schwankungsbreite einen Schwellwert für die Schwankungsbreite nicht überschreitet, Extrapolieren (110) der Fließkommawerte (F) aus der Nachbarschaft, um einen Schätzwert (S) für einen vorbestimmten Fließkommawert (I) zu erhalten, wobei die Einrichtung zum Decodieren (210) ausgebildet ist, einen Mantissen-Restwert für den vorbestimmten Fließkommawert (I) zu decodieren; und
   einer Einrichtung zum Ermitteln (230) eines Mantissenwertes des vorbestimmten Fließkommawertes (I) aus dem Mantissen-Restwert und aus dem Schätzwert (S) für den vorbestimmten Fließkommawert (I).

6. Vorrichtung nach Anspruch 5, bei dem die Einrichtung zum Ermitteln (230) ausgebildet ist, den ursprünglichen Mantissenwert durch eine Addition oder Subtraktion des Mantissen-Restwertes und des Mantissenwertes des Schätzwertes (S) zu bestimmen.

7. Vorrichtung nach Anspruch 5 oder 6, bei der die Einrichtung zum Codieren so ausgebildet ist, dass der Schwellwert $\pm1$ oder $\pm2$ beträgt.

8. Vorrichtung nach einem der Ansprüche 5 bis 7, bei der die Einrichtung zum Decodieren (210) ausgebildet ist eine Dekompression der codierten Fließkommazahlen. (F') durchzuführen.

**9.** Vorrichtung nach einem der vorhergehenden Ansprüche, bei der die Einrichtung zum Extrapolieren (110) ausgebildet ist, den Schätzwert (S) durch eine lineare Extrapolation von zwei Fließkommawerten aus der Nachbarschaft zu erhalten.

**10.** Vorrichtung nach einem der vorhergehenden Ansprüche, bei der die Einrichtung zum Extrapolieren (110) ausgebildet ist, aus der Nachbarschaft des vorbestimmten Fließkommawertes Fließkommawerte zu bestimmen, die einen kleinsten Gradienten in Richtung des vorbestimmten Fließkommawertes aufweisen.

**11.** Vorrichtung nach einem der vorhergehenden Ansprüche, bei dem die Einrichtung zum Extrapolieren (110) ausgebildet ist, den Mantissenwert des Schätzwertes (S) durch einen Minimalwert im Wertebereich des Mantissenwertes zu ersetzen, wenn der Exponent des Schätzwertes (S) kleiner ist als der Exponent des vorbestimmten Fließkommawertes (I), oder
bei dem die Einrichtung zum Extrapolieren (110) ausgebildet ist, den Mantissenwert des Schätzwertes (S) durch einen Maximalwert im Wertebereich des Mantissenwertes zu ersetzen, wenn der Exponent des Schätzwertes (S) größer ist als der Exponent des vorbestimmten Fließkommawertes (I).

**12.** Vorrichtung nach einem der vorhergehenden Ansprüche, bei der die Mehrzahl von Fließkommawerten (F) Bildpunkten eines abzutastenden Bildes entspricht und bei der die Einrichtung zum Extrapolieren (110) ausgebildet ist, als Nachbarschaft für den vorbestimmten Fließkommawert (I) Fließkommawerte zu berücksichtigen, die Bildpunkten entsprechen, die entgegen der Abtastrichtung gelegen sind.

**13.** Verfahren zum Codieren einer Mehrzahl von Fließkommawerten (F), wobei die Mehrzahl von Fließkommawerten (F) Helligkeitswerten von abzutastenden Bildpunkten entspricht und die Bildpunkte in Blöcke unterteilt sind, wobei jeder Block eine vorbestimmte Anzahl von Bildpunkten aufweist, mit Bestimmen einer Schwankungsbreite der Exponenten der Mehrzahl von Fließkommawerten (F) in den Blöcken;
Weiterleiten von Blöcken, bei denen die Schwankungsbreite einen Schwellwert für die Schwankungsbreite überschreitet, zu einer Codierung ohne Extrapolation;
für Blöcke, bei denen die Schwankungsbreite einen Schwellwert für die Schwankungsbreite nicht überschreitet, Extrapolieren (110) der Fließkommawerte (F) aus einer Nachbarschaft eines vorbestimmten Fließkommawertes der Mehrzahl von Fließkommawerten (F), um einen Schätzwert (S) für den vorbestimmten Fließkommawert (I) zu erhalten;
einer Einrichtung zum Ermitteln (120) eines Mantissen-Restwertes abhängig von einer Differenz der Mantisse des Schätzwertes und der Mantisse des vorbestimmten Fließkommawerts (I); und
Codieren (130) des vorbestimmten Fließkommawertes durch Codieren eines Exponenten des vorbestimmten Fließkommawertes (F) und des Mantissen-Restwerts.

**14.** Verfahren zum Decodieren einer Mehrzahl von codierten Fließkommawerten (F'), wobei die Mehrzahl von codierten Fließkommawerten Helligkeitswerten von Bildpunkten entspricht und die Bildpunkte in Blöcke unterteilt sind, wobei jeder Block eine vorbestimmte Anzahl von Bildpunkten aufweist, mit
Decodieren eines Exponenten der Fließkommawerte (I);
Bestimmen einer Schwankungsbreite der Exponenten der Mehrzahl von Fließkommawerten (F) in den Blöcken;
Weiterleiten von Blöcken, bei denen die Schwankungsbreite einen Schwellwert für die Schwankungsbreite überschreitet, zu einer Deodierung ohne Extrapolation;
für Blöcke, bei denen die Schwankungsbreite einen Schwellwert für die Schwankungsbreite nicht überschreitet, Extrapolieren (110) der Fließkommawerte (F) aus der Nachbarschaft, um einen Schätzwert (S) für einen vorbestimmten Fließkommawert (I) zu erhalten,
Decodieren eines Mantissen-Restwert für den vorbestimmten Fließkommawert (I); und
Ermitteln (230) eines Mantissenwertes des vorbestimmten Fließkommawertes (I) aus dem Mantissen-Restwert und aus dem Schätzwert (S) für den vorbestimmten Fließkommawert (I).

**15.** Computerprogramm mit einem Programmcode, der ausgebildet ist, bei Ablauf auf einem Computer das Verfahren nach Anspruch 13 oder Anspruch 14 durchzuführen.

**Claims**

**1.** Device for encoding a plurality of floating-point values (F), said plurality of floating-point values (F) corresponding to brightness values of pixels to be sampled, and the pixels being subdivided into blocks, each block comprising a predetermined number of pixels, comprising
means for encoding (130) configured to determine a range of variation of the exponents of said plurality of floating-point values (F) within the blocks and to forward blocks wherein the range of variation exceeds a threshold value for the range of variation to encoding without extrapolation;
a means for extrapolating (110) - for blocks wherein the range of variation does not exceed a threshold value for the range of variation - the floating-point values (F) from a neighborhood of a predetermined floating-point value of the plurality of floating-point values (F) so as to obtain an estimate (S) for the predetermined floating-point value (I); and
means for determining (120) -for the blocks wherein the range of variation does not exceed a threshold value for the range of variation - a residual mantissa value as a function of a difference between the mantissa of the estimate and the mantissa of the predetermined floating-point value (I); and
the means for encoding (130) being configured to encode - for the blocks wherein the range of variation does not exceed a threshold value for the range of variation - the predetermined floating-point value by encoding an exponent of the predetermined floating-point value (F) and of the residual mantissa value.

2. Device as claimed in claim 1, further comprising means for extracting component signals, said component signals comprising a red component (810r), a green component (810g), and a blue component (810b).

3. Device as claimed in claims 1 or 2, wherein the means for encoding is configured such that the threshold value is $\pm 1$ or $\pm 2$.

4. Device as claimed in any of the previous claims, further comprising means for compressing (815, 817; 821), said for compressing (815, 817; 821) being configured to compress the residual mantissa values.

5. Device for decoding a plurality of encoded floating-point values (F'), said plurality of encoded floating-point values corresponding to brightness values of pixels, and the pixels being subdivided into blocks, each block comprising a predetermined number of pixels, comprising
means for decoding (210) configured to decode an exponent of the floating-point values (I) and to determine a range of variation of the exponents of said plurality of floating-point values (F) within the blocks and to forward blocks wherein the range of variation exceeds a threshold value for the range of variation to decoding without extrapolation;
a means for extrapolating (110) - for blocks wherein the range of variation does not exceed a threshold value for the range of variation - the floating-point values (F) from the neighborhood so as to obtain an estimate (S) for a predetermined floating-point value (I), the means for decoding (210) being configured to decode a residual mantissa value for the predetermined floating-point value (I); and
means for determining (230) a mantissa value of the predetermined floating-point value (I) from the residual mantissa value and from the estimate (S) for the predetermined floating-point value (I).

6. Device as claimed in claim 5, wherein the means for determining (230) is configured to determine the original mantissa value by means of an addition or subtraction of the residual mantissa value and the mantissa value of the estimate (S).

7. Device as claimed in claims 5 or 6, wherein the means for encoding is configured such that the threshold value is $\pm 1$ or $\pm 2$.

8. Device as claimed in any of claims 5 to 7, wherein the means for decoding (210) is configured to perform a decompression of the encoded floating-point numbers (F').

9. Device as claimed in any of the previous claims, wherein the means for extrapolating (110) is configured to obtain the estimate (S) by means of a linear extrapolation of two floating-point values from the neighborhood.

10. Device as claimed in any of the previous claims, wherein the means for extrapolating (110) is configured to determine, from the neighborhood of the predetermined floating-point value, floating-point values comprising a smallest gradient in the direction of the predetermined floating-point value.

11. Device as claimed in any of the previous claims, wherein the means for extrapolating (110) is configured to replace the mantissa value of the estimate (S) by a minimum value within the range of values of the mantissa value if the exponent of the estimate (S) is smaller than the exponent of the predetermined floating-point value (I), or
wherein the means for extrapolating (110) is configured to replace the mantissa value of the estimate (S) by a maximum value within the range of values of the mantissa value if the exponent of the estimate (S) is larger than the exponent of the predetermined floating-point value (I).

12. Device as claimed in any of the previous claims, wherein the plurality of floating-point values (F) correspond to pixels of an image to be sampled, and wherein the means for extrapolating (110) is configured to consider, as the neighborhood for the predetermined floating-point value (I), such floating-point values which correspond to pixels that are located against the sampling direction.

13. Method of encoding a plurality of floating-point values (F), said plurality of floating-point values (F) corresponding to brightness values of pixels to be sampled, and the pixels being subdivided into blocks, each block comprising a predetermined number of pixels, comprising
determining a range of variation of the exponents of the plurality of floating-point values (F) within the blocks;
forwarding blocks wherein the range of variation exceeds a threshold value for the range of variation to encoding without extrapolation;
for blocks wherein the range of variation does not exceed a threshold value for the range of variation,
extrapolating (110) the floating-point values (F) from a neighborhood of a predetermined floating-point value of the plurality of floating-point values (F) so as to obtain an estimate (S) for the predetermined floating-point value (I);
means for determining (120) a residual mantissa value as a function of a difference between the mantissa of the estimate and the mantissa of the predetermined floating-point value (I); and
encoding (130) the predetermined floating-point value by encoding an exponent of the predetermined floating-point value (F) and of the residual mantissa value.

14. Method of decoding a plurality of encoded floating-point values (F'), said plurality of encoded floating-point values corresponding to brightness values of pixels, and the pixels being subdivided into blocks, each block comprising a predetermined number of pixels, comprising
decoding an exponent of the floating-point values (I);
determining a range of variation of the exponents of the plurality of floating-point values (F) within the blocks;
forwarding blocks wherein the range of variation exceeds a threshold value for the range of variation to decoding without extrapolation;
for blocks wherein the range of variation does not exceed a threshold value for the range of variation,
extrapolating (110) the floating-point values (F) from the neighborhood so as to obtain an estimate (S) for a predetermined floating-point value (I),
decoding a residual mantissa value for the predetermined floating-point value (I); and
determining (230) a mantissa value of the predetermined floating-point value (I) from the residual mantissa value and from the estimate (S) for the predetermined floating-point value (I).

15. Computer program comprising a program code configured to perform, when running on a computer, the method as claimed in claim 13 or in claim 14.

**Revendications**

1. Dispositif pour coder une pluralité de valeurs à virgule flottante (F), ladite pluralité de valeurs à virgule flottante (F) correspondant à des valeurs de luminance des pixels à balayer, et les pixels étant subdivisés en blocs, chaque bloc présentant un nombre prédéterminé de pixels, avec
un moyen destiné à coder (130) qui est réalisé pour déterminer une ampleur de variation des exposants de la pluralité de valeurs à virgule flottante (F) dans les blocs et pour transmettre les blocs dans lesquels l'ampleur de variation excède une valeur de seuil pour l'ampleur de variation à un codage sans extrapolation;
un moyen destiné à extrapoler (110), pour les blocs dans lesquels l'ampleur de variation n'excède pas une valeur de seuil pour l'ampleur de variation, les valeurs à virgule flottante (F) d'un voisinage d'une valeur à virgule flottante prédéterminée de la pluralité de valeurs à virgule flottante (F), pour obtenir une valeur estimée (S) pour la valeur à virgule flottante prédéterminée (I); et un moyen pour déterminer (120), pour les blocs dans lesquels l'ampleur de variation n'excède pas une valeur de seuil pour l'ampleur de variation, une valeur résiduelle de mantisse en fonction d'une différence entre la mantisse de la valeur estimée et la mantisse de la valeur à virgule flottante prédéterminée (I); et dans lequel le moyen destiné à coder (130) est réalisé pour coder, pour les blocs dans lesquels l'ampleur de variation n'excède pas une valeur de seuil pour l'ampleur de variation, la valeur à virgule flottante prédéterminée en codant un exposant de la valeur à virgule flottante prédéterminée (F) et de la valeur résiduelle de mantisse.

2. Dispositif selon la revendication 1, présentant par ailleurs un moyen destiné à extraire des signaux à composantes, les signaux à composantes présentant une composante rouge (810r), une composante verte (810g) et une composante bleue (310b).

3. Dispositif selon la revendication 1 ou 2, dans lequel le moyen destiné à coder est réalisé de sorte que la valeur de seuil soit de $\pm 1$ ou $\pm 2$.

4. Dispositif selon l'une des revendications précédentes, présentant par ailleurs un moyen destiné à comprimer (815, 817; 821), le moyen destiné à comprimer (815, 817; 821) étant réalisé pour comprimer les valeurs résiduelles de mantisse.

5. Dispositif pour décoder une pluralité de valeurs à virgule flottante codées (F'), la pluralité de valeurs à virgule flottante codées correspondant à des valeurs de luminance de pixels et les pixels étant subdivisés en blocs, chaque bloc présentant un nombre prédéterminé de pixels, avec
   un moyen destiné à décoder (210) qui est réalisé pour décoder un exposant des valeurs à virgule flottante (I) et pour déterminer une ampleur de variation des exposants de la pluralité de valeurs à virgule flottante (F) dans les blocs et transmettre les blocs dans lesquels l'ampleur de variation excède une valeur de seuil pour l'ampleur de variation à un décodage sans extrapolation;
   un moyen destiné à extrapoler (110), pour les blocs dans lesquels l'ampleur de variation n'excède pas une valeur de seuil pour l'ampleur de variation, les valeurs à virgule flottante (F) du voisinage, pour obtenir une valeur estimée (S) pour une valeur à virgule flottante prédéterminée (I), le moyen destiné à décoder (210) étant réalisé pour décoder une valeur résiduelle de mantisse pour la valeur à virgule flottante prédéterminée (I); et
   un moyen destiné à déterminer (230) une valeur de mantisse de la valeur à virgule flottante prédéterminée (I) à partir de la valeur résiduelle de mantisse et de la valeur estimée (S) pour la valeur à virgule flottante prédéterminée (I).

6. Dispositif selon la revendication 5, dans lequel le moyen destiné à déterminer (230) est réalisé pour déterminer la valeur de mantisse originale par une addition ou soustraction de la valeur résiduelle de mantisse et de la valeur de mantisse de la valeur estimée (S).

7. Appareil selon la revendication 5 ou 6, dans lequel le moyen destiné à coder est réalisé de sorte que la valeur de seuil soit de $\pm 1$ on $\pm 2$.

8. Dispositif selon l'une des revendications 5 à 7, dans lequel le moyen destiné à décoder (210) est réalisé pour effectuer une décompression des nombres à virgule flottante codés (F').

9. Dispositif selon l'une des revendications précédentes, dans lequel le moyen destiné à extrapoler (110) est réalisé pour recevoir la valeur estimée (S) par une extrapolation linéaire de deux valeurs à virgule flottante du voisinage.

10. Dispositif selon l'une des revendications précédentes, dans lequel le moyen pour extrapoler (110) est réalisé pour déterminer, à partir du voisinage de la valeur à virgule flottante, des valeurs à virgule flottante prédéterminées présentant un gradient le plus petit en direction de la valeur à virgule flottante prédéterminée.

11. Dispositif selon l'une des revendications précédentes, dans lequel le moyen destiné à extrapoler (110) est réalisé pour remplacer la valeur de mantisse de la valeur estimée (S) par une valeur minimale dans la plage de valeurs de la valeur de mantisse lorsque l'exposant de la valeur estimée (S) est inférieur à l'exposant de la valeur à virgule flottante prédéterminée (I), ou dans lequel le moyen destiné à extrapoler (110) est réalisé pour remplacer la valeur de mantisse de la valeur estimée (S) par une valeur maximale dans la plage de valeurs de la valeur de mantisse lorsque l'exposant de la valeur estimée (S) est supérieur à l'exposant de la valeur à virgule flottante prédéterminée (I).

12. Dispositif selon l'une des revendications précédentes, dans lequel la pluralité de valeurs à virgule flottante (F) correspondent à des pixels d'une image à balayer et dans lequel le moyen destiné à extrapoler (110) est réalisé pour tenir compte, comme voisinage de la valeur à virgule flottante prédéterminée (I), des valeurs à virgule flottante correspondant à des pixels qui sont situés à l'encontre de la direction de balayage.

13. Procédé de codage d'une pluralité de valeurs à virgule flottante (F), la pluralité de valeurs à virgule flottante (F) correspondant à des valeurs de luminance des pixels à balayer, et les pixels étant subdivisés en blocs, chaque bloc présentant un nombre prédéterminé de pixels, avec le fait de
   déterminer une ampleur de variation des exposants de la pluralité de valeurs à virgule flottante (F) dans les blocs;
   transmettre les blocs dans lesquels l'ampleur de variation excède une valeur de seuil pour l'ampleur de variation à un codage sans extrapolation;

pour les blocs dans lesquels l'ampleur de variation n'excède pas une valeur de seuil pour l'ampleur de variation, extrapoler (110) les valeurs à virgule flottante (F) d'un voisinage d'une valeur à virgule flottante prédéterminée de la pluralité de valeurs à virgule flottante (F), pour obtenir une valeur estimée (S) pour la valeur à virgule flottante prédéterminée (I);

un moyen destiné à déterminer (120) une valeur résiduelle de mantisse en fonction d'une différence entre la mantisse de la valeur estimée et la mantisse de la valeur à virgule flottante prédéterminée (I); et

coder (130) la valeur à virgule flottante prédéterminée en codant un exposant de la valeur à virgule flottante prédéterminée (F) et de la valeur résiduelle de mantisse.

14. Procédé de décodage d'une pluralité de valeurs à virgule flottante codées (F'), la pluralité de valeurs à virgule flottante codées correspondant à des valeurs de luminance de pixels et les pixels étant subdivisés en blocs, chaque bloc présentant un nombre prédéterminé de pixels, avec le fait de

décoder un exposant des valeurs à virgule flottante (1);

déterminer une ampleur de variation des exposants de la pluralité de valeurs à virgule flottante (F) dans les blocs;

transmettre les blocs dans lesquels l'ampleur de variation excède une valeur de seuil pour l'ampleur de variation à un décodage sans extrapolation;

pour les blocs dans lesquels l'ampleur de variation n'excède pas une valeur de seuil pour l'ampleur de variation, extrapoler (110) les valeurs à virgule flottante (F) du voisinage, pour obtenir une valeur estimée (S) pour une valeur à virgule flottante prédéterminée (I),

décoder une valeur résiduelle de mantisse pour la valeur à virgule flottante prédéterminée (I); et

déterminer (230) une valeur de mantisse de la valeur à virgule flottante prédéterminée (I) à partir de la valeur résiduelle de mantisse et de la valeur estimée (S) pour la valeur à virgule flottante prédéterminée (I).

15. Programme d'ordinateur avec un code de programme qui est conçu pour réaliser, lorsqu'il est exécuté sur un ordinateur, le procédé selon la revendication 13 ou la revendication 14.

Einrichtung zum Extrapolieren von Fließkommawerten — 110

Einrichtung zum Ermitteln eines Mantissen-Restwertes — 120

Einrichtung zum Codieren des vorbestimmten Fließkommawertes — 130

F'

FIG 1A

F' →

Einrichtung zum Decodieren
von codierten Fließkommawerten — 210

↓

Einrichtung zum Extrapolieren
der Fließkommawerte — 220

↓

Einrichtung zum Ermitteln eines
ursprünglichen Mantissenwertes — 230

↓

F

FIG 1B

FIG 2A

FIG 2B

EP 2 294 825 B1

Für jeden Fließkomma-
Kanal:

Für jeden Block von
Fließkommazahlen
innerhalb des Kanals:

Keine Anwendung des
Prädiktions-Verfahrens
(Schätzwerte vermutlich nicht
ausreichend genau)

nein ← Ist der Block
geeignet? → ja

Für jede im Block
enthaltene
Fließkommazahl:

Matissenprädiktion

Bilde einen Schätzwert
dieser Fließkommazahl

Bestimme die Differenz
zwischen Mantisse der
Fließkommazahl und
der Mantisse des
Schätzwertes

Ersetze den
Mantissenwert der
Fließkommazahl mit
der berechneten
Differenz

FIG 3A

Für jede im Block enthaltene Fließkommazahl:

Bilde einen Schätzwert dieser Fließkommazahl auf Basis der vorhergehenden Fließkommazahlen

siehe FIG 4,5

Exponent des Schätzwertes = Exponent der FK-Zahl?

ja

nein

Exponent des Schätzwertes < Exponent der FK-Zahl?

nein

ja

Wähle die Mantisse des Schätzwertes zu 1023

Wähle die Mantisse des Schätzwertes zu 0

Extrahiere Mantisse des Schätzwertes (Qualität der Schätzung wird als gut angenommen)

Bestimme die Differenz zwischen Mantisse der Fließkommazahl und der Mantisse des Schätzwertes

Ersetze den Mantissenwert der Fließkommazahl mit der berechneten Differenz

FIG 3B

| NNWW | NNW | NN | NNE |
|------|-----|----|----|
| WWN  | NW  | N  | NE |
| WW   | W   | I  |    |

# FIG 4

```
┌─────────────────────┐     ┌─────────────────────┐     ┌─────────────────────┐     ┌─────────────────────┐
│  Bildung des        │     │                     │     │  Bewertung der      │     │                     │
│  Kontextes          │     │  Berechnung der     │     │  berechneten        │     │  Lineare Schätzung  │
│  des zu schätzenden │     │  lokalen            │     │  Gradienten         │     │  (Geradengleichung) │
│  Fließkommawertes   │ ──> │  Gradienten für die │ ──> │  (kleinster         │ ──> │  in                 │
│  (Ermittlung der    │     │  Richtungen W, N, NW│     │  Gradient           │     │  Richtung des       │
│  relevanten         │     │  und NE             │     │  verspricht beste   │     │  kleinsten          │
│  Nachbarschaftswerte)│    │                     │     │  Schätzung)         │     │  Gradienten         │
└─────────────────────┘     └─────────────────────┘     └─────────────────────┘     └─────────────────────┘
```

FIG 5

# FIG 6

EP 2 294 825 B1

| | | Vorzeichen | Exponent | Mantisse 2 Bits links | Mantisse 8 Bits rechts | Wert der Mantisse | dargestellter Wert |
|---|---|---|---|---|---|---|---|
| Vorgänger 1 (NN) | Binär | 0 | 1111 | 11 | 11100000 | | |
| | Dezimal | 0 | 15 | 3 | 224 | 992 | 1,96875 |
| Vorgänger 2 (N) | Binär | 0 | 1111 | 11 | 11111111 | | |
| | Dezimal | 0 | 15 | 3 | 255 | 1023 | 1,999023438 |
| Schätzwert | Binär | 0 | 10000 | 0 | 1111 | | |
| | Dezimal | 0 | 16 | 0 | 15 | 15 | 2,029296875 |
| tatsächlicher wert | Binär | 0 | 10000 | 0 | 11111 | | |
| | Dezimal | 0 | 16 | 0 | 31 | 31 | 2,060546875 |

## Mantissendifferenz mit Schätzverfahren      31-15 = 16

### Zum Vergleich: Mantissendifferenz ohne Schätzverfahren      31-1023 = -992

### Werte der Fließkommazahlen

```
2,08
2,06
2,04
2,02
2
1,98
1,96
1,94
1,92
     NN        N        I
```

tatsächlicher Wert

Schätzwert S

### Werte der zugehörigen Mantissen

```
1200
1000
 800
 600
 400
 200
   0
     NN        N        I
```

Angenommene Mantisse ohne Schätzverfahren

Schätzverfahren verhindert großen Sprung zweier benachbarter Samplewerte (Mantissen)

tatsächlicher Wert

Mantisse des Schätzwertes S

FIG 7A

tatsächliche Mantisse

geschätzte Mantisse

Residuals

FIG 7B

tatsächliche Mantisse  geschätzte Mantisse  Residuals

FIG 7C

EP 2 294 825 B1

FIG 8A

FIG 8B

EP 2 294 825 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **ISENBURG et al.** Lossless Compression of Floating-Point Geometry. *PROCEEDINGS OF CAD04,* 24. Mai 2004

- **GAMITO et al.** Lossless Coding of Floating Point Data with JPEG 2000 Part 10. *PROCEEDINGS OF THE INTERNATIONAL SOCIETY FOR OPTICAL ENGINEERING,* 02. August 2004, vol. 5558, 276-287